# EUROPEAN PATENT APPLICATION

(11) **EP 4 842 179 A1**
(43) Date of publication of application: **18.11.2026**
(21) Application number: 26178009.2
(22) Date of filing: 11.05.2026
(51) Int. Cl.: H10K 59/80, H10K 59/40

(54) **DISPLAY DEVICE AND ELECTRONIC DEVICE**

(30) Priority: 16.05.2025 KR 20250063592
(71) Applicant: Samsung Display Co., Ltd., Yongin-si, Gyeonggi-do 17113 (KR)
(72) Inventor: LEE, Dong Cheol, Yongin-si (KR); KANG, Seul Woo, Yongin-si (KR); GONG, Su Cheol, Yongin-si (KR); BAE, Ki Chul, Yongin-si (KR)
(74) Representative: Marks & Clerk LLP

(57) **Abstract**

The present disclosure relates to a display device, and more particularly, to a display device and an electronic device in which a defect of a display panel caused by external impact may be reduced or minimized. The display device (10) includes: a substrate (SUB) including a main area (MA); a light emitting element (ED) on a display area (DA) of the main area (MA); and a cover layer (CVL) on the display area (DA) and a non-display area (NDA) of the main area (MA) of the substrate covering the light emitting element (ED), wherein an edge of the main area (MA) includes a main side (MS1) and a main corner (MC1), and wherein an edge of the cover layer (CVL) includes a first cover side (CS1) overlapping the main side (MS1) and a cover corner (CC1) spaced from the main corner (MC1).

## Description

### BACKGROUND

### 1. Technical Field

The present disclosure relates to a display device, and more particularly, to a display device and an electronic device in which a defect of a display panel caused by external impact may be reduced or minimized.

### 2. Description of the Related Art

An organic light emitting display apparatus includes display elements whose luminance is changed by a current, such as organic light emitting diodes.

### SUMMARY

Aspects and features of embodiments of the present disclosure provide a display device and an electronic device in which a defect of a display panel caused by external impact may be reduced or minimized.

According to one or more embodiments of the present disclosure, a display device includes: a substrate including a main area; a light emitting element on a display area of the main area; and a cover layer on the display area and a non-display area of the main area of the substrate covering the light emitting element, wherein an edge of the main area includes a main side and a main corner, and wherein an edge of the cover layer includes a first cover side overlapping the main side and a cover corner spaced from the main corner.

According to one or more embodiments, each of the main corner and the cover corner has a curved shape.

According to one or more embodiments, the cover corner includes a plurality of sub-cover corners having curved shapes convex in different directions.

According to one or more embodiments, the plurality of sub-cover corners includes: a first sub-cover corner having a curved shape convex toward the main corner; and a second sub-cover corner having a curved shape convex toward the display area of the main area.

According to one or more embodiments, the display device further includes at least one trench located between the cover corner and the main corner.

According to one or more embodiments, the at least one trench includes: a first trench located between the cover corner and the main corner; and a second trench located between the first trench and the main corner.

According to one or more embodiments, the at least one trench includes a plurality of sub-trenches having different shapes.

According to one or more embodiments, the plurality of sub-trenches includes: a first sub-trench having a curved shape; and a second sub-trench extending from the first sub-trench toward the main corner and having a straight shape.

According to one or more embodiments, the cover layer further includes: a second cover side neighboring to the first cover side and connected to the first cover side by the cover corner; a third cover side connecting one side of the cover corner and the first cover side to each other; and a fourth cover side connecting an other side of the cover corner and the second cover side to each other.

According to one or more embodiments, the at least one trench is located in a corner area that is surrounded by the cover corner, the third cover side, the fourth cover side, and the main corner.

According to one or more embodiments, the display device further includes: an encapsulation layer on the light emitting element; a touch inorganic film on the encapsulation layer; and a touch organic film on the touch inorganic film, wherein the cover layer is on the touch organic film.

According to one or more embodiments, the display device further includes a trench between the cover corner and the main corner and penetrating through the touch organic film and the touch inorganic film.

According to one or more embodiments, the display device further includes a polarizing layer on the cover layer, wherein an adhesive layer of the polarizing layer is in the trench.

According to one or more embodiments, the cover layer has a greater step at the cover corner than at the first cover side.

According to one or more embodiments, the cover layer includes an organic material.

According to one or more embodiments, the substrate further includes a sub-area that is adjacent to the main area and does not overlap the cover layer, and wherein the display device further includes a pad portion in the sub-area and a display driver connected to the pad portion.

According to one or more embodiments, an electronic device including a display device includes a display screen, wherein the display device includes: a substrate including a main area; a light emitting element on a display area of the main area; and a cover layer on the display area and a non-display area of the main area of the substrate covering the light emitting element, wherein an edge of the main area includes a main side and a main corner, and wherein an edge of the cover layer includes a cover side overlapping the main side and a cover corner spaced from the main corner.

According to one or more embodiments, the electronic device further includes a frame located along the main side and the main corner, wherein the frame is in contact with the main side and the cover side.

According to one or more embodiments, the frame and the cover corner are not in contact with each other.

According to one or more embodiments, the electronic device includes a smartphone, a tablet personal computer (PC), a laptop computer, a television (TV), a monitor for a desktop computer, smart glasses, a smart watch, a head mounted display, or a vehicle.

At least some of the above and other features of the invention are set out in the claims.

With a display device and an electronic device according to one or more embodiments, a defect of a display panel due to external impact may be reduced or minimized.

For example, a main side of an edge of a main area of the display panel and a main side of a cover layer overlap each other, while a main corner of the edge of the main area and a main corner of the cover layer are spaced apart from each other, and thus, a separation problem between the cover layer and a touch organic film in a corner area due to external impact may be solved.

The effects of the present disclosure are not limited to the above-described effects and other effects which are not described herein will become apparent to those skilled in the art from the following description.

### BRIEF DESCRIPTION OF THE DRAWINGS

The above and other aspects and features of the present disclosure will become more apparent by describing in detail embodiments thereof with reference to the attached drawings, in which:
FIG. 1 is a perspective view illustrating a display device according to one or more embodiments;
FIG. 2 is a plan view of a display panel of FIG. 1;
FIG. 3 is a cross-sectional view illustrating the display device according to one or more embodiments;
FIG. 4 is a block diagram illustrating a display panel and a display driver according to one or more embodiments;
FIG. 5 is a circuit diagram of one pixel of the display device according to one or more embodiments;
FIG. 6 is a plan view of a display panel including a cover layer and trenches added to FIG. 2;
FIG. 7 is an enlarged view of an area A of the display panel of FIG. 6 according to one or more embodiments;
FIG. 8 is an enlarged view of the area A of the display panel of FIG. 6 according to one or more embodiments;
FIG. 9 is an enlarged view of the area A of the display panel of FIG. 6 according to one or more embodiments;
FIG. 10 is an enlarged view of an area A of the display panel of FIG. 6 according to one or more embodiments;
FIG. 11 is a cross-sectional view of the display device according to one or more embodiments taken along the line I-I' of FIG. 7;
FIG. 12 is a cross-sectional view of the display device according to one or more embodiments taken along the line II-II' of FIG. 7;
FIG. 13 is a cross-sectional view of the display device according to one or more embodiments taken along the line III-III' of FIG. 7;
FIGS. 14 and 15 are views for describing an effect of the display device according to one or more embodiments;
FIG. 16 is a block diagram of an electronic device according to one or more embodiments; and
FIGS. 17 - 19 are schematic views of electronic devices according to various embodiments.

### DETAILED DESCRIPTION OF THE EMBODIMENTS

The present disclosure will now be described more fully hereinafter with reference to the accompanying drawings, in which embodiments of the present disclosure are shown. The present disclosure may, however, be embodied in different forms and should not be construed as limited to the embodiments set forth herein. Rather, these embodiments are provided so that the present disclosure will be thorough and complete, and will fully convey the scope of the present disclosure to those skilled in the art.

It will also be understood that when a layer is referred to as being "on" another layer or substrate, it can be directly on the other layer or substrate, or intervening layers may also be present. The same reference numbers indicate the same components throughout the specification. In the attached figures, the thickness of layers and regions is exaggerated for clarity.

Although the terms "first", "second", etc. may be used herein to describe various elements, these elements, should not be limited by these terms. These terms may be used to distinguish one element from another element. Thus, a first element discussed below may be termed a second element without departing from teachings of one or more embodiments. The description of an element as a "first" element may not require or imply the presence of a second element or other elements. The terms "first", "second", etc. may also be used herein to differentiate different categories or sets of elements. For conciseness, the terms "first", "second", etc. may represent "first-category (or first-set)", "second-category (or second-set)", etc., respectively.

Throughout the specification, in a case in which a portion is "connected" to another portion, the case includes not only a case in which the portion is directly connected but also a case in which the portion is indirectly connected to one or more other elements interposed therebetween. Terms used herein are for describing specific embodiments and are not intended to limit the present disclosure. Throughout the specification, in a case in which a certain portion "includes," the case means that the portion may further include another component without excluding another component unless otherwise stated. "At least one of X, Y, and Z," "at least one of X, Y, or Z," and "at least one selected from the group consisting of X, Y, and Z" may be construed as X only, Y only, Z only, any combination of two or more of X, Y, and Z, such as, for instance, XYZ, XYY, YZ, and ZZ, or any variation thereof. The term "and/or" includes any and all combinations of one or more of the associated listed items.

Spatially relative terms, such as "under," "on," and the like may be used for descriptive purposes, thereby describing a relationship between one element or feature and another element(s) or feature(s) as shown in the drawings. Spatially relative terms are intended to include other directions in use, in operation, and/or in manufacturing, in addition to the direction depicted in the drawings. For example, when a device shown in the drawing is turned upside down, elements depicted as being positioned "under" other elements or features are positioned in a direction "on" the other elements or features. Therefore, in an embodiment, the term "under" may include both directions of on and under. In addition, the device may face in other directions (for example, rotated 90 degrees or in other directions) and, thus, the spatially relative terms used herein are interpreted according thereto.

Various embodiments are described with reference to drawings schematically illustrating example embodiments. Accordingly, it will be expected that shapes may vary, for example, according to tolerances and/or manufacturing techniques. Therefore, embodiments disclosed herein are not to be construed as being limited to shown specific shapes, and are to be interpreted as including, for example, changes in shapes that may occur as a result of manufacturing. As described above, the shapes shown in the drawings may not show actual shapes of areas of a device, and the present embodiments are not limited thereto.

A person of ordinary skill in the art would appreciate, in view of the present disclosure in its entirety, that each suitable feature of the various embodiments of the present disclosure may be combined or combined with each other, partially or entirely, and may be technically interlocked and operated in various suitable ways, and each embodiment may be implemented independently of each other or in conjunction with each other in any suitable manner unless otherwise stated or implied.

Features of various embodiments of the present disclosure may be combined partially or totally. As will be clearly appreciated by those skilled in the art, technically various interactions and operations are possible. Various embodiments can be practiced individually or in combination.

Hereinafter, example embodiments will be described with reference to the accompanying drawings.

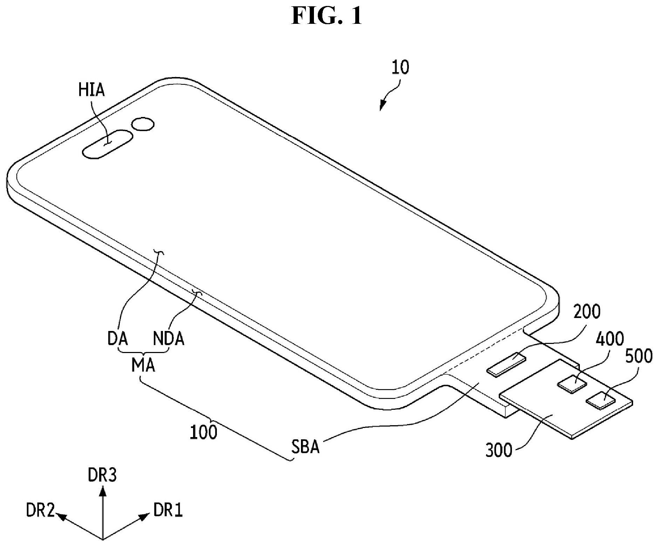

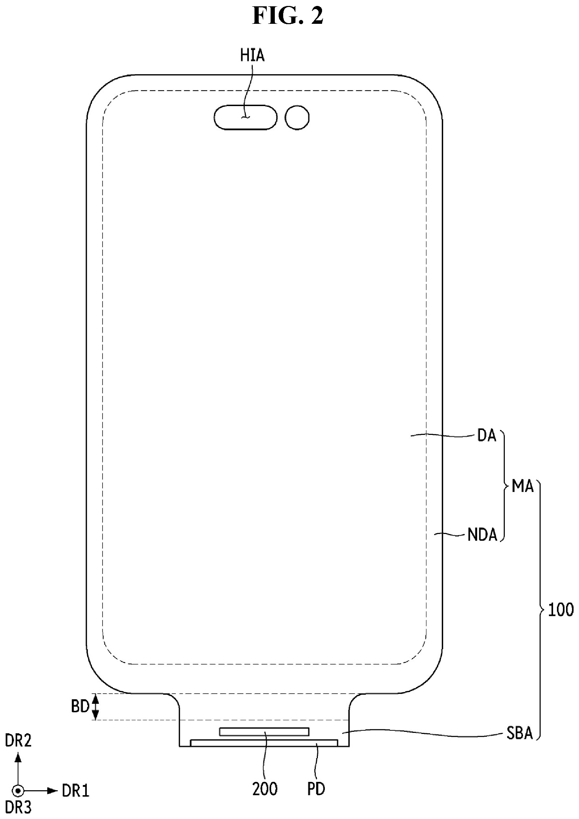

FIG. 1 is a perspective view illustrating a display device according to one or more embodiments, and FIG. 2 is a plan view of a display panel of FIG. 1.

Referring to FIGS. 1 and 2, a display device 10 may be applied to portable electronic devices such as mobile phones, smartphones, tablet personal computers (PCs), mobile communication terminals, electronic notebooks, electronic books, portable multimedia players (PMPs), navigation devices, and ultra mobile PCs (UMPCs). As an example, the display device 10 may be applied as a display unit of televisions, laptop computers, monitors, billboards, or the Internet of Things (IOTs). As another example, the display device 10 may be applied to wearable devices such as smart watches, watch phones, glasses-type displays, and head mounted displays (HMDs).

The display device 10 may have a shape similar to a rectangular shape in a plan view. For example, the display device 10 may have a shape similar to a rectangular shape, in a plan view, having short sides in a first direction DR1 and long sides in a second direction DR2. A corner where the short side in the first direction DR1 and the long side in the second direction DR2 meet may be rounded with a selected curvature or right-angled. The shape of the display device 10 in a plan view is not limited to the rectangular shape, and may be a shape similar to other polygonal shapes, a circular shape, or an elliptical shape.

The display device 10 may include a display panel 100, a display driver 200, a circuit board 300, a touch driver 400, and a power supply unit 500.

The display panel 100 may include a main area MA and a sub-area SBA.

The main area MA may include a display area DA including pixels for displaying an image and a non-display area NDA disposed around the display area DA. The display area DA may emit light from a plurality of emission areas or a plurality of opening areas. For example, the display panel 100 may include pixel circuits including switching elements, a pixel defining film defining the emission areas or the opening areas, and self-light emitting elements.

For example, the self-light emitting element may include at least one of an organic light emitting diode (OLED) including an organic light emitting layer, a quantum dot LED including a quantum dot light emitting layer, an inorganic LED including an inorganic semiconductor, and a micro LED, but is not limited thereto.

The non-display area NDA may be an area outside the display area DA. The non-display area NDA may be defined as an edge area of the main area MA of the display panel 100. The non-display area NDA may include a gate driver for supplying gate signals to gate lines and fan-out lines for connecting the display driver 200 and the display area DA (e.g., connecting the display driver 200 and the pixels in the display area DA) to each other.

The sub-area SBA may extend from one side of the main area MA. The sub-area SBA may include a flexible material that may be bent, folded, and/or rolled. For example, when the sub-area SBA is bent, the sub-area SBA may overlap the main area MA in a thickness direction (e.g., a third direction DR3). The sub-area SBA may include the display driver 200 and pad portions connected to the circuit board 300. Alternatively, the sub-area SBA may be omitted, and the display driver 200 and the pad portions may be disposed in the non-display area NDA.

The display driver 200 may output signals and voltages for driving the display panel 100. The display driver 200 may supply data voltages to data lines. The display driver 200 may supply source voltages to power lines and supply gate control signals to the gate driver. The display driver 200 may be formed as an integrated circuit (IC) and mounted on the display panel 100 in a chip on glass (COG) manner, a chip on plastic (COP) manner, or an ultrasonic bonding manner. As an example, the display driver 200 may be disposed in the sub-area SBA, and may overlap the main area MA in the thickness direction (third direction DR3) by bending of the sub-area SBA. As another example, the display driver 200 may be mounted on the circuit board 300.

The circuit board 300 may be attached onto the pad portions of the display panel 100 using an anisotropic conductive film (ACF). Lead lines of the circuit board 300 may be electrically connected to the pad portions of the display panel 100. The circuit board 300 may be a flexible printed circuit board (FPCB), a printed circuit board (PCB), or a flexible film such as a chip on film (CoF).

The touch driver 400 may be mounted on the circuit board 300. The touch driver 400 may be electrically connected to a touch sensor unit TSU of the display panel 100. The touch driver 400 may supply touch driving signals to a plurality of touch electrodes of the touch sensor unit TSU and sense change amounts in capacitance between the plurality of touch electrodes. For example, the touch driving signal may be a pulse signal having a selected frequency. The touch driver 400 may decide whether or not an input has occurred and calculate input coordinates, based on the change amounts in capacitance between the plurality of touch electrodes. The touch driver 400 may be formed as an integrated circuit (IC).

The power supply unit 500 may be disposed on the circuit board 300 and may supply source voltages to the display driver 200 and the display panel 100. The power supply unit 500 may generate a driving voltage and supply the driving voltage to a driving voltage line VDL, may generate initialization voltages (e.g., a first initialization voltage and a second initialization voltage) and supply the initialization voltages to initialization voltage lines (e.g., a first initialization voltage line VIL1 and a second initialization voltage line VIL2), and may generate a common voltage and supply the common voltage to a common electrode common to light emitting elements of a plurality of pixels. For example, the driving voltage may be a high-potential voltage for driving the light emitting element, and the common voltage may be a low-potential voltage for driving the light emitting element.

The display device 10 may further include at least one through hole HIA penetrating through the display device in the third direction DR3. The through hole HIA is a hole capable of transmitting light, and an example in which two through holes are disposed is illustrated in FIGS. 1 and 2. The through hole HIA may be, for example, an area where an optical module is disposed. The optical module may emit light of infrared, ultraviolet, and visible ray bands or receive the light of the infrared, ultraviolet, and visible ray bands. For example, the optical module may include an optical sensor for sensing light incident on the display device 10, such as a proximity sensor, an illuminance sensor, a camera sensor, or an image sensor. For example, the proximity sensor may be disposed in any one of the two through holes HIA, and the camera sensor may be disposed in the other of the two through holes HIA.

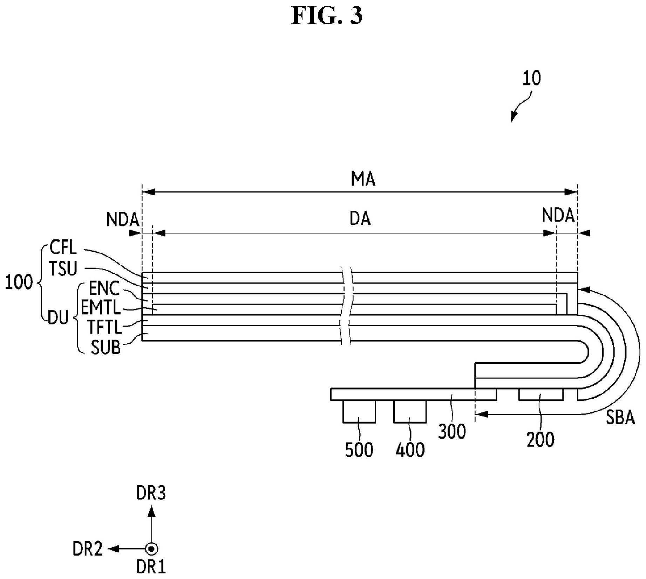

FIG. 3 is a cross-sectional view illustrating the display device according to one or more embodiments.

Referring to FIG. 3, the display panel 100 may include a display unit DU, a touch sensor unit TSU, and a color filter layer CFL. The display unit DU may include a substrate SUB, a thin film transistor layer TFTL, a light emitting element layer EMTL, and an encapsulation layer ENC.

The substrate SUB may be a base substrate or a base member. The substrate SUB may be a flexible substrate that may be bent, folded, and/or rolled. As an example, the substrate SUB may include a polymer resin such as polyimide (PI), but is not limited thereto. As another example, the substrate SUB may include a glass material or a metal material.

The thin film transistor layer TFTL may be disposed on the substrate SUB. The thin film transistor layer TFTL may include a plurality of thin film transistors constituting pixel circuits of pixels. The thin film transistor layer TFTL may further include gate lines, data lines, power lines, gate control lines, fan-out lines connecting the display driver 200 and the data lines to each other, and lead lines connecting the display driver 200 and the pad portions to each other. Each of the thin film transistors may include a semiconductor region, a source electrode, a drain electrode, and a gate electrode. For example, when a gate driver is formed on one side of the non-display area NDA of the display panel 100, the gate driver may include thin film transistors (TFTs).

The thin film transistor layer TFTL may be disposed in the display area DA, the non-display area NDA, and the sub-area SBA. The thin film transistors of each of the pixels, the gate lines, the data lines, and the power lines of the thin film transistor layer TFTL may be disposed in the display area DA. The gate control lines and the fan-out lines of the thin film transistor layer TFTL may be disposed in the non-display area NDA. The lead lines of the thin film transistor layer TFTL may be disposed in the sub-area SBA.

The light emitting element layer EMTL may be disposed on the thin film transistor layer TFTL. The light emitting element layer EMTL may include a plurality of light emitting elements in which a pixel electrode, a light emitting layer, and a common electrode are sequentially stacked to emit light and a pixel defining film defining the pixels. The plurality of light emitting elements of the light emitting element layer EMTL may be disposed in the display area DA.

For example, the light emitting layer may be an organic light emitting layer including an organic material. The light emitting layer may include a hole transporting layer, an organic light emitting layer, and an electron transporting layer. When the pixel electrode receives a selected voltage through the thin film transistor of the thin film transistor layer TFTL and the common electrode receives a cathode voltage, holes and electrons may move to the organic light emitting layer through the hole transporting layer and the electron transporting layer, respectively, and may be combined with each other in the organic light emitting layer to emit light. For example, the pixel electrode may be an anode electrode and the common electrode may be a cathode electrode, but the present disclosure is not limited thereto.

As another example, the plurality of light emitting elements may include quantum dot light emitting diodes each including a quantum dot light emitting layer, inorganic light emitting diodes each including an inorganic semiconductor, or micro light emitting diodes.

The encapsulation layer ENC may cover an upper surface and side surfaces of the light emitting element layer EMTL, and may protect the light emitting element layer EMTL. The encapsulation layer ENC may include at least one inorganic layer and at least one organic layer for encapsulating the light emitting element layer EMTL.

The touch sensor unit TSU may be disposed on the encapsulation layer ENC. The touch sensor unit TSU may include a plurality of touch electrodes for sensing a user's touch in a capacitance manner and touch lines connecting the plurality of touch electrodes and the touch driver 400 to each other. For example, the touch sensor unit TSU may sense the user's touch in a mutual capacitance manner or a self-capacitance manner.

As another example, the touch sensor unit TSU may be disposed on a separate substrate disposed on the display unit DU. In this case, the substrate supporting the touch sensor unit TSU may be a base member encapsulating the display unit DU.

The plurality of touch electrodes of the touch sensor unit TSU may be disposed in a touch sensor area overlapping the display area DA. The touch lines of the touch sensor unit TSU may be disposed in a touch peripheral area overlapping the non-display area NDA.

The color filter layer CFL may be disposed on the touch sensor unit TSU. The color filter layer CFL may include a plurality of color filters respectively corresponding to the plurality of emission areas. Each of the color filters may selectively transmit light of a specific wavelength and block or absorb light of other wavelengths. The color filter layer CFL may absorb some of light introduced from the outside of the display device 10 to reduce reflected light by external light. Accordingly, the color filter layer CFL may prevent distortion of colors due to external light reflection.

Because the color filter layer CFL is directly disposed on the touch sensor unit TSU, the display device 10 may not require a separate substrate for the color filter layer CFL. Accordingly, a thickness of the display device 10 may be relatively reduced.

The sub-area SBA of the display panel 100 may extend from one side of the main area MA. The sub-area SBA may include a flexible material that may be bent, folded, and/or rolled. For example, when the sub-area SBA is bent, the sub-area SBA may overlap the main area MA in the thickness direction (e.g., the third direction DR3). The sub-area SBA may include the display driver 200 and the pad portions PD connected to the circuit board 300.

As illustrated in FIGS. 2 and 3, at least a portion of the sub-area SBA may be bent. For example, the sub-area may include a bending area BD where the display panel 100 is bent. The bending area BD may be located between the display area DA and the pad portion PD (or the display driver 200).

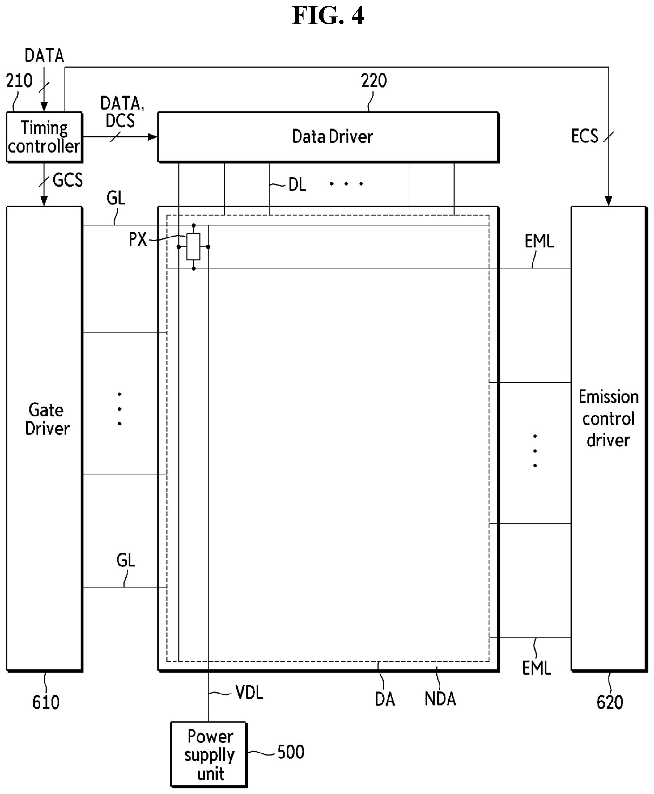

FIG. 4 is a block diagram illustrating a display panel 100 and a display driver 200 according to one or more embodiments.

Referring to FIG. 4, the display panel 100 may include a display area DA and a non-display area NDA.

The display area DA may include a plurality of pixels PX and a plurality of driving voltage lines VDL, a plurality of gate lines GL, a plurality of emission control lines EML, and a plurality of data lines DL that are connected to the plurality of pixels PX.

Each of the plurality of pixels PX may be connected to the gate line GL, the data line DL, the emission control line EML, the driving voltage line VDL, and a common voltage line. Each of the plurality of pixels PX may include at least one transistor, a light emitting element, and a capacitor.

The gate lines GL may sequentially supply gate signals to the plurality of pixels PX.

The emission control lines EML may sequentially supply emission control signals to the plurality of pixels PX.

The data lines DL may supply data voltages to the plurality of pixels PX. The data voltage may determine luminance of each of the plurality of pixels PX.

The driving voltage lines VDL may supply driving voltages to the plurality of pixels PX. The driving voltage may be a high-potential voltage for driving the light emitting elements of the pixels PX.

The non-display areas NDA may be around (e.g., may surround) the display area DA. A gate driver 610 and an emission control driver 620 may be disposed in the non-display area NDA.

The gate driver 610 may include a write scan driver including a plurality of write scan transistors, a control scan driver including a plurality of control scan transistors, an initialization scan driver including a plurality of initialization scan transistors, and a bias scan driver including a plurality of bias scan transistors.

The emission control driver 620 may include a plurality of emission control transistors.

The display driver 200 may include a timing controller 210 and a data driver 220.

The timing controller 210 may receive digital video data DATA and timing signals from the circuit board 300. The timing controller 210 may control an operation timing of the data driver 220 by generating a data control signal DCS based on the timing signals, may control an operation timing of the gate driver 610 by generating a gate control signal GCS based on the timing signals, and may control an operation timing of the emission control driver 620 by generating an emission control signal ECS based on the timing signals. In addition, the timing controller 210 may supply the digital video data DATA and the data control signal DCS to the data driver 220.

The data driver 220 may convert the digital video data DATA into analog data voltages and supply the analog data voltages to the data lines DL through fan-out lines. Gate signals of the gate driver 610 may select pixels PX to which the data voltages are supplied, and the selected pixels PX may receive the data voltages through the data lines DL.

The power supply unit 500 may be disposed on the circuit board 300 and may supply source voltages to the display driver 200 and the display panel 100. The power supply unit 500 may generate a driving voltage and supply the driving voltage to the driving voltage line VDL, and may generate a common voltage and supply the common voltage to a common electrode common to the light emitting elements of the plurality of pixels PX. Here, the common voltage may be supplied to the light emitting elements of the pixels through the common voltage line.

The gate driver 610 may be disposed outside one side of the display area DA or on one side of the non-display area NDA, and the emission control driver 620 may be disposed outside the other side of the display area DA or on the other side of the non-display area NDA, but the present disclosure is not limited thereto. As another example, the gate driver 610 and the emission control driver 620 may be disposed on any one of one side and the other side of the non-display area NDA.

The gate driver 610 may include a plurality of transistors for generating gate signals based on the gate control signal GCS. The emission control driver 620 may include a plurality of transistors for generating emission control signals based on the emission control signal ECS. For example, the transistors of the gate driver 610 and the transistors of the emission control driver 620 may be formed at a same layer as the transistors of each of the pixels PX. The gate driver 610 may supply the gate signals to the gate lines GL, and the emission control driver 620 may supply the emission control signals to the emission control lines EML.

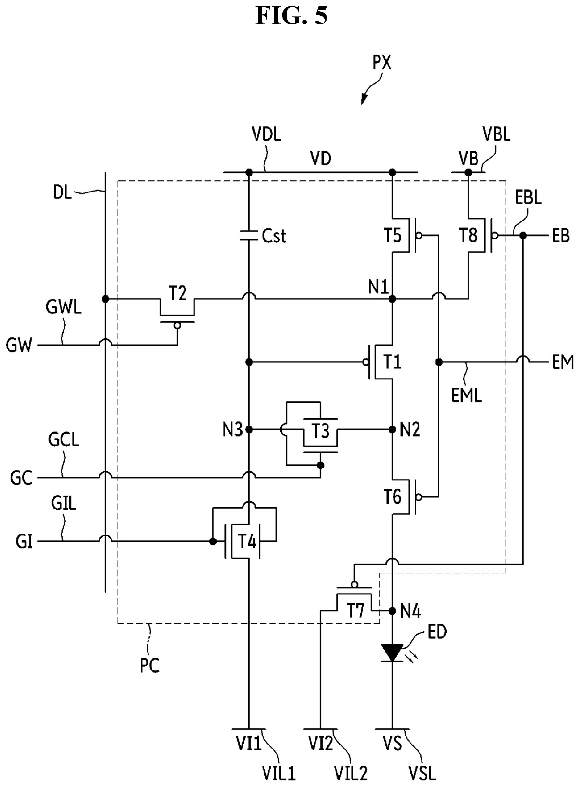

FIG. 5 is a circuit diagram of one pixel PX of the display device according to one or more embodiments. For example, FIG. 5 may be a circuit diagram of the pixel PX of FIG. 2 or FIG. 4.

The pixel PX may be connected to a first gate line GWL, a second gate line GCL, a third gate line GIL, a fourth gate line EBL, an emission control line EML, a data line DL, a driving voltage line VDL, a common voltage line VSL, a first initialization voltage line VIL1, a second initialization voltage line VIL2, and a bias voltage line VBL, as illustrated in FIG. 5.

The pixel PX may include a pixel circuit PC and a light emitting element ED. The pixel circuit PC may include a first transistor T1, a second transistor T2, a third transistor T3, a fourth transistor T4, a fifth transistor T5, a sixth transistor T6, a seventh transistor T7, an eighth transistor T8, and a capacitor Cst.

The first transistor T1 may include a gate electrode, a source electrode, and a drain electrode. The first transistor T1 may control a source-drain current (e.g., a driving current) according to a data voltage applied to the gate electrode of the first transistor T1. The driving current flowing through a channel region of the first transistor T1 may be proportional to the square of a difference between a voltage between the source electrode and the gate electrode and a threshold voltage of the first transistor T1.

The light emitting element ED may emit light by receiving the driving current. An amount of light emitted from the light emitting element ED or luminance of the light emitting element ED may be proportional to a magnitude of the driving current.

The light emitting element ED may be an organic light emitting diode (OLED) including a first electrode, a second electrode, and an organic light emitting layer disposed between the first electrode and the second electrode. As another example, the light emitting element ED may be an inorganic light emitting element including a first electrode, a second electrode, and an inorganic semiconductor disposed between the first electrode and the second electrode. As still another example, the light emitting element ED may be a quantum dot light emitting element including a first electrode, a second electrode, and a quantum dot light emitting layer disposed between the first electrode and the second electrode. As still another example, the light emitting element ED may be a micro light emitting diode.

The first electrode of the light emitting element ED may be connected to a fourth node N4. The first electrode of the light emitting element ED may be connected to a drain electrode of the sixth transistor T6 and a source electrode of the seventh transistor T7 through the fourth node N4. The second electrode of the light emitting element ED may be connected to the common voltage line VSL. The second electrode of the light emitting element ED may receive a common voltage VS (e.g., a low-potential voltage) from the common voltage line VSL.

The second transistor T2 may be turned on by a first gate signal GW of the first gate line GWL to electrically connect the data line DL and a first node N1, which is the source electrode of the first transistor T1, to each other. The second transistor T2 may be turned on based on the first gate signal to supply a data voltage to the first node N1. A gate electrode of the second transistor T2 may be electrically connected to the first gate line GWL, a source electrode of the second transistor T2 may be electrically connected to the data line DL, and a drain electrode of the second transistor T2 may be electrically connected to the first node N1.

The third transistor T3 may be turned on by a second gate signal GC of the second gate line GCL to electrically connect a second node N2, which is the drain electrode of the first transistor T1, and a third node N3, which is the gate electrode of the first transistor T1, to each other. The third transistor T3 may be connected between the third node N3 and the second node N2. For example, a gate electrode of the third transistor T3 may be electrically connected to the second gate line GCL, a source electrode of the third transistor T3 may be electrically connected to the third node N3, and a drain electrode of the third transistor T3 may be electrically connected to the second node N2. The third transistor T3 may be turned on by the second gate signal of the second gate line GCL to electrically connect the second node N2, which is the drain electrode of the first transistor T1, and the third node N3, which is the gate electrode of the first transistor T1, to each other. As such, when the third transistor T3 is turned on, the first transistor T1 may be diode-connected. The third transistor T3 may be a double gate transistor having two gate electrodes (e.g., a gate electrode and a counter gate electrode). The gate electrode and the counter gate electrode may be disposed at different layers so as to face each other.

The fourth transistor T4 may be turned on by a third gate signal GI of the third gate line GIL to electrically connect the third node N3, which is the gate electrode of the first transistor T1, and the first initialization voltage line VIL1 to each other. The fourth transistor T4 may be connected in series between the third node N3 and the first initialization voltage line VIL1. For example, a gate electrode of the fourth transistor T4 may be electrically connected to the third gate line GIL, a source electrode of the fourth transistor T4 may be electrically connected to the third node N3, and a drain electrode of the fourth transistor T4 may be electrically connected to the first initialization voltage line VIL1. The fourth transistor T4 may be a double gate transistor. The first initialization voltage line VIL1 may transmit a first initialization voltage VI1.

The fifth transistor T5 may be turned on by an emission control signal EM of the emission control line EML to electrically connect the driving voltage line VDL and the first node N1, which is the source electrode of the first transistor T1, to each other. A gate electrode of the fifth transistor T5 may be electrically connected to the emission control line EML, a source electrode of the fifth transistor T5 may be electrically connected to the driving voltage line VDL, and a drain electrode of the fifth transistor T5 may be electrically connected to the first node N1.

The sixth transistor T6 may be turned on by the emission control signal EM of the emission control line EML to electrically connect the second node N2, which is the drain electrode of the first transistor T1, and the fourth node N4, which is the first electrode of the light emitting element ED, to each other. A gate electrode of the sixth transistor T6 may be electrically connected to the emission control line EML, a source electrode of the sixth transistor T6 may be electrically connected to the second node N2, and the drain electrode of the sixth transistor T6 may be electrically connected to the fourth node N4.

When the fifth transistor T5, the first transistor T1, and the sixth transistor T6 are all turned on, the driving current may be supplied to the light emitting element ED.

The seventh transistor T7 may be turned on by a fourth gate signal EB of the fourth gate line EBL to electrically connect the fourth node N4, which is the first electrode of the light emitting element ED, and the second initialization voltage line VIL2 to each other. The seventh transistor T7 may be turned on based on the fourth gate signal to discharge the first electrode of the light emitting element ED to a second initialization voltage VI2. A gate electrode of the seventh transistor T7 may be electrically connected to the fourth gate line EBL, the source electrode of the seventh transistor T7 may be electrically connected to the fourth node N4, and a drain electrode of the seventh transistor T7 may be electrically connected to the second initialization voltage line VIL2. The second initialization voltage line VIL2 may transmit the second initialization voltage VI2.

The eighth transistor T8 may be turned on by the fourth gate signal EB of the fourth gate line EBL to electrically connect the bias voltage line VBL and the first node N1, which is the source electrode of the first transistor T1, to each other. The eighth transistor T8 may be turned on based on the fourth gate signal to supply a bias voltage VB to the first node N1. The eighth transistor T8 may improve hysteresis of the first transistor T1 by supplying the bias voltage VB to the source electrode of the first transistor T1. A gate electrode of the eighth transistor T8 may be electrically connected to the fourth gate line EBL, a source electrode of the eighth transistor T8 may be electrically connected to the bias voltage line VBL, and a drain electrode of the eighth transistor T8 may be electrically connected to the first node N1.

Each of the first transistor T1, the second transistor T2, the fifth transistor T5, the sixth transistor T6, the seventh transistor T7, and the eighth transistor T8 may include a silicon-based active layer. For example, each of the first transistor T1, the second transistor T2, the fifth transistor T5, the sixth transistor T6, the seventh transistor T7, and the eighth transistor T8 may be a P-type transistor including an active layer made of low temperature polycrystalline silicon (LTPS). The active layer made of the low temperature polycrystalline silicon may have high electron mobility and excellent turn-on characteristics. Accordingly, the display device 10 may stably and efficiently drive the plurality of pixels PX by including the transistors having the excellent turn-on characteristics. Each of the first transistor T1, the second transistor T2, the fifth transistor T5, the sixth transistor T6, the seventh transistor T7, and the eighth transistor T8 may output a current introduced into the source electrode to the drain electrode based on a gate low voltage applied to the gate electrode.

Each of the third transistor T3 and the fourth transistor T4 may be an N-type transistor including an oxide-based active layer. The transistor including the oxide-based active layer may have a coplanar structure in which a gate electrode thereof is disposed at a top. The transistor including the oxide-based active layer may output a current introduced into a drain electrode to a source electrode based on a gate high voltage applied to the gate electrode.

The capacitor Cst may be electrically connected between the third node N3, which is the gate electrode of the first transistor T1, and the driving voltage line VDL. For example, the capacitor Cst may have a first electrode electrically connected to the third node N3 and a second electrode electrically connected to the driving voltage line VDL to maintain a potential difference between the driving voltage line VDL and the gate electrode of the first transistor T1.

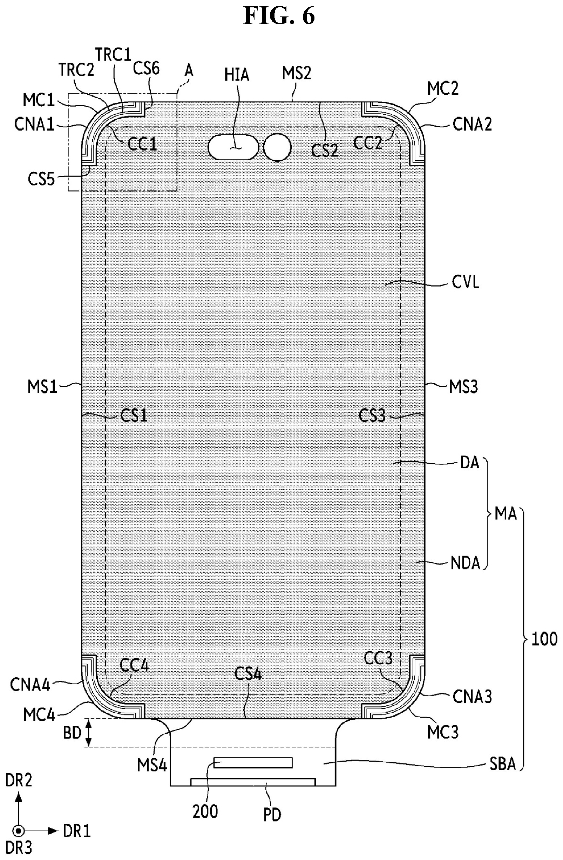

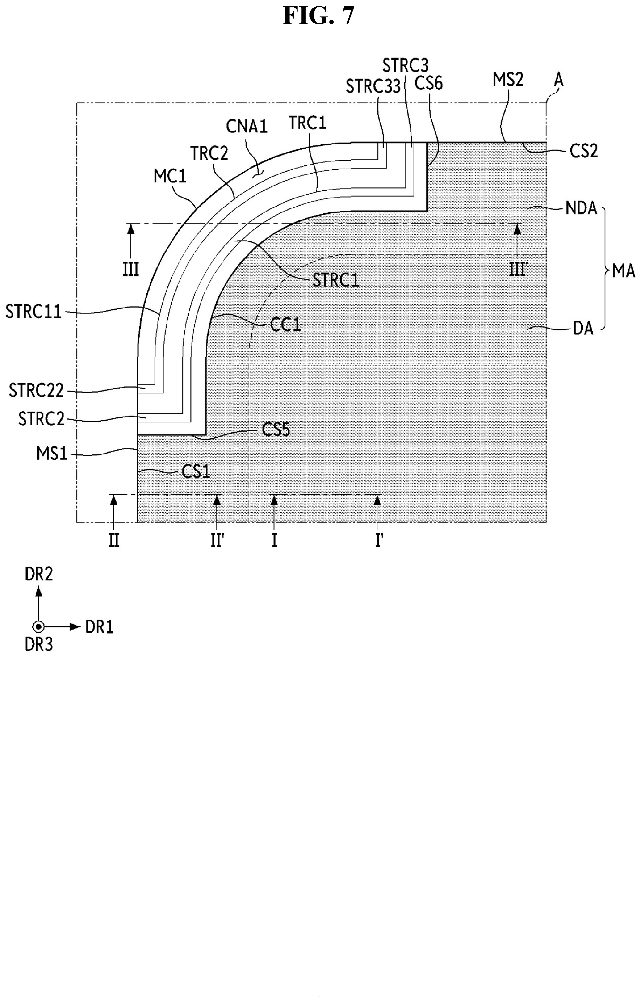

FIG. 6 is a plan view of a display panel 100 including a cover layer CVL and trenches added to FIG. 2, and FIG. 7 is an enlarged view of an area A the display panel 100 of FIG. 6 according to one or more embodiments.

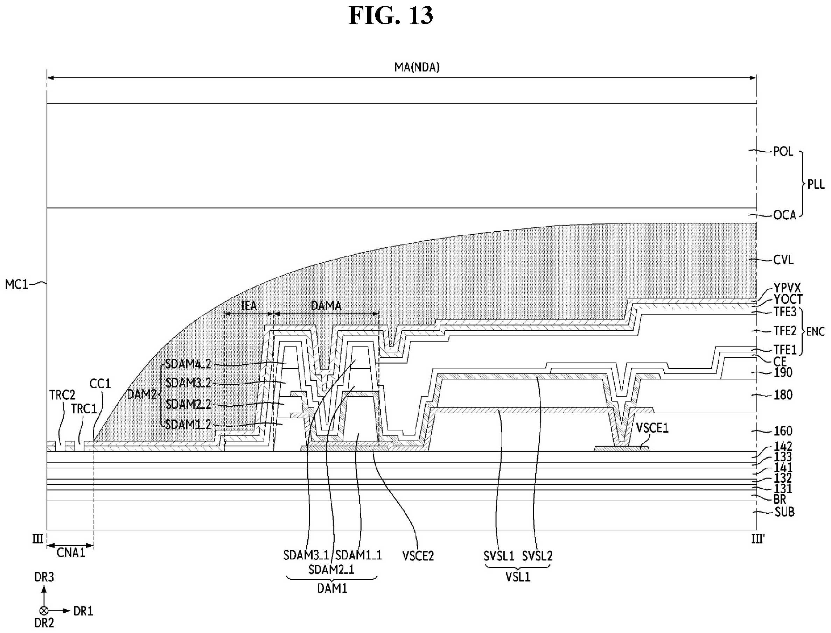

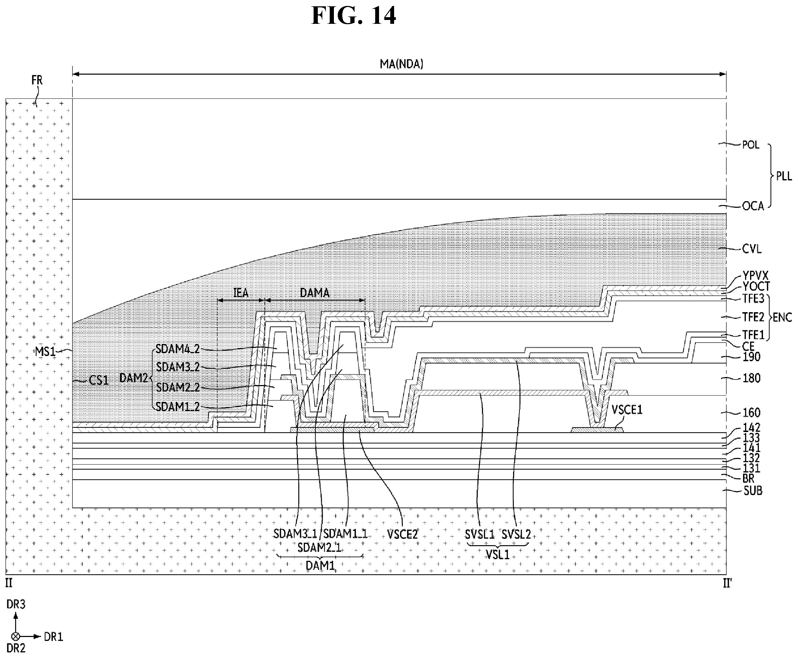

As illustrated in FIG. 6, an edge of the display panel 100 (e.g., a substrate SUB of FIGS. 13 and 14) may include a plurality of sides MS1, MS2, MS3, and MS4 (hereinafter referred to as main sides) and a plurality of corners MC1, MC2, MC3, and MC4 (hereinafter referred to as main corners). For example, an edge of the main area MA of the display panel 100 (e.g., the substrate SUB of FIGS. 13 and 14) may include a plurality of main sides MS1, MS2, MS3, and MS4 and a plurality of main corners MC1, MC2, MC3, and MC4. A main corner may be located between two main sides neighboring to each other.

The edge of the main area MA may include a first main side MS1 located on the left side of the main area MA, a second main side MS2 located on the upper side of the main area MA so as to neighbor to the first main side MS1, a third main side MS3 located on the right side of the main area MA so as to neighbor to the second main side MS2, a fourth main side MS4 located on the lower side of the main area MA so as to neighbor to the third main side MS3, a first main corner MC1 connecting the first main side MS1 and the second main side MS2 to each other, a second main corner MC2 connecting the second main side MS2 and the third main side MS3 to each other, a third main corner MC3 connecting the third main side MS3 and the fourth main side MS4 to each other, and a fourth main corner MC4 connecting the fourth main side MS4 and the first main side MS1 to each other.

Each of the main sides MS1, MS2, MS3, and MS4 may have a straight shape. For example, each of the first and third main sides MS1 and MS3 facing each other in the first direction DR1 may have a straight shape in which it extends along the second direction DR2, and each of the second and fourth main sides MS2 and MS4 facing each other in the second direction DR2 may have a straight shape in which it extends along the first direction DR1.

The main corner may be located between two main sides neighboring to each other. For example, two main sides extending in directions crossing each other and neighboring to each other may be connected to each other by the main corner. As a specific example, the first main corner MC1 may be disposed between the first main side MS1 and the second main side MS2, the second main corner MC2 may be disposed between the second main side MS2 and the third main side MS3, the third main corner MC3 may be disposed between the third main side MS3 and the fourth main side MS4, and the fourth main corner MC4 may be disposed between the fourth main side MS4 and the first main side MS1.

Each of the main corners MC1, MC2, MC3, and MC4 may have a curved shape. For example, each of the main corners MC1, MC2, MC3, and MC4 may have a curved shape convex toward the outside of the display panel 100.

The display panel 100 may further include the cover layer CVL. The cover layer CVL may planarize a step and an inclined surface of the display panel 100. The cover layer CVL may be formed as an organic film made of an acrylic resin, an epoxy resin, a phenolic resin, a polyamide resin, a polyimide resin, and/or the like.

The cover layer CVL may be disposed in the main area MA. For example, the cover layer CVL may overlap the main area MA. The cover layer CVL may not overlap the sub-area SBA. Accordingly, the cover layer CVL may not overlap the pad portion PD and the display driver 200 of the sub-area SBA.

An edge of the cover layer CVL may overlap the main sides MS1, MS2, MS3, and MS4 of the main area MA. For example, the edge of the cover layer CVL may be aligned with each of the main sides MS1, MS2, MS3, and MS4 of the main area MA. The edge of the cover layer CVL may not overlap the main corners MC1, MC2, MC3, and MC4 of the main area MA. For example, the edge of the cover layer CVL may be spaced (e.g., spaced apart) from each of the main corners MC1, MC2, MC3, and MC4 of the main area MA. As a specific example, in a plan view, the main corners MC1, MC2, MC3, and MC4 of the main area MA and the edge of the cover layer CVL facing each other may be spaced (e.g., spaced apart) from each other.

The edge of the cover layer CVL may include a plurality of sides CS1, CS2, CS3, and CS4 (hereinafter referred to as cover sides) and a plurality of corners CC1, CC2, CC3, and CC4 (hereinafter referred to as cover corners). For example, the edge of the cover layer CVL may include a first cover side CS1, a second cover side CS2, a third cover side CS3, a fourth cover side CS4, a plurality of fifth cover sides CS5, a plurality of sixth cover sides CS6, a first cover corner CC1, a second cover corner CC2, a third cover corner CC3, and a fourth cover corner CC4.

Each of the first cover side CS1, the second cover side CS2, the third cover side CS3, the fourth cover side CS4, the plurality of fifth cover sides CS5, and the plurality of sixth cover sides CS6 of the cover layer CVL may have a straight shape. A shape of the first cover side CS1, a shape of the second cover side CS2, a shape of the third cover side CS3, and a shape of the fourth cover side CS4 may be the same as the shape of the first main side MS1, the shape of the second main side MS2, the shape of the third main side MS3, and the shape of the fourth main side MS4 described above, respectively.

Each of the first cover corner CC1, the second cover corner CC2, the third cover corner CC3, and the fourth cover corner CC4 of the cover layer CVL may have a curved shape. For example, a shape of the first cover corner CC1, a shape of the second cover corner CC2, a shape of the third cover corner CC3, and a shape of the fourth cover corner CC4 may be the same as the shape of the first main corner MC1, the shape of the second main corner MC2, the shape of the third main corner MC3, and the shape of the fourth main corner MC4 described above, respectively.

The cover corner of the cover corner and the main corner facing each other may have a greater curvature. For example, a curvature of the first cover corner CC1 may be greater than a curvature of the first main corner MC1, a curvature of the second cover corner CC2 may be greater than a curvature of the second main corner MC2, a curvature of the third cover corner CC3 may be greater than a curvature of the third main corner MC3, and a curvature of the fourth cover corner CC4 may be greater than a curvature of the fourth main corner MC4.

The first cover side CS1 of the cover layer CVL may overlap the first main side MS1 of the main area MA, the second cover side CS2 of the cover layer CVL may overlap the second main side MS2 of the main area MA, the third cover side CS3 of the cover layer CVL may overlap the third main side MS3 of the main area MA, and the fourth cover side CS4 of the cover layer CVL may overlap the fourth main side MS4 of the main area MA. For example, the first cover side CS1 of the cover layer CVL may be aligned with the first main side MS1 of the main area MA, the second cover side CS2 of the cover layer CVL may be aligned with the second main side MS2 of the main area MA, the third cover side CS3 of the cover layer CVL may be aligned with the third main side MS3 of the main area MA, and the fourth cover side CS4 of the cover layer CVL may be aligned with the fourth main side MS4 of the main area MA.

The fifth cover side CS5 of the cover layer CVL may connect a cover corner and an end of a cover side adjacent to one end of the cover corner to each other, and the sixth cover side CS6 of the cover layer CVL may connect the cover corner and an end of a cover side adjacent to the other end of the cover corner to each other. For example, the fifth cover side CS5 may connect one end of the first cover corner CC1 and one end of the first cover side CS1 to each other, and the sixth cover side CS6 may connect the other end of the first cover corner CC1 and one end of the second cover side CS2 to each other.

The first cover corner CC1 of the cover layer CVL may face the first main corner MC1 of the main area MA, the second cover corner CC2 of the cover layer CVL may face the second main corner MC2 of the main area MA, the third cover corner CC3 of the cover layer CVL may face the third main corner MC3 of the main area MA, and the fourth cover corner CC4 of the cover layer CVL may face the fourth main corner MC4 of the main area MA.

The first cover corner CC1 of the cover layer CVL and the first main corner MC1 of the main area MA may be spaced (e.g., spaced apart) from each other, the second cover corner CC2 of the cover layer CVL and the second main corner MC2 of the main area MA may be spaced (e.g., spaced apart) from each other, the third cover corner CC3 of the cover layer CVL and the third main corner MC3 of the main area MA may be spaced (e.g., spaced apart) from each other, and the fourth cover corner CC4 of the cover layer CVL and the fourth main corner MC4 of the main area MA may be spaced (e.g., spaced apart) from each other. For example, the first cover corner CC1 of the cover layer CVL and the first main corner MC1 of the main area MA may be spaced (e.g., spaced apart) from each other by a length of the fifth cover side CS5 (or the sixth cover side CS6), the second cover corner CC2 of the cover layer CVL and the second main corner MC2 of the main area MA may be spaced (e.g., spaced apart) from each other by the length of the fifth cover side CS5 (or the sixth cover side CS6), the third cover corner CC3 of the cover layer CVL and the third main corner MC3 of the main area MA may be spaced (e.g., spaced apart) from each other by the length of the fifth cover side CS5 (or the sixth cover side CS6), and the fourth cover corner CC4 of the cover layer CVL and the fourth main corner MC4 of the main area MA may be spaced (e.g., spaced apart) from each other by the length of the fifth cover side CS5 (or the sixth cover side CS6).

An area between the cover corner of the cover layer CVL and the main corner of the main area MA facing each other may be defined as a corner area. For example, an area between the first cover corner CC1 of the cover layer CVL and the first main corner MC1 of the main area MA may be defined as a first corner area CNA1. In a plan view, the first corner area CNA1 may be surrounded by the first cover corner CC1 of the cover layer CVL, the first main corner MC1 of the main area MA, the fifth cover side CS5 of the cover layer CVL, and the sixth cover side CS6 of the cover layer CVL. In addition, in a plan view, a second corner area CNA2 may be surrounded by the second cover corner CC2 of the cover layer CVL, the second main corner MC2 of the main area MA, the fifth cover side CS5 of the cover layer CVL, and the sixth cover side CS6 of the cover layer CVL. Further, in a plan view, a third corner area CNA3 may be surrounded by the third cover corner CC3 of the cover layer CVL, the third main corner MC3 of the main area MA, the fifth cover side CS5 of the cover layer CVL, and the sixth cover side CS6 of the cover layer CVL. Further, in a plan view, a fourth corner area CNA4 may be surrounded by the fourth cover corner CC4 of the cover layer CVL, the fourth main corner MC4 of the main area MA, the fifth cover side CS5 of the cover layer CVL, and the sixth cover side CS6 of the cover layer CVL.

At least one trench TRC1 or TRC2 may be formed in each of the corner areas CNA1, CNA2, CNA3, and CNA4. Because structures and shapes of the trenches TRC1 and TRC2 disposed in each of the corner areas CNA1, CNA2, CNA3, and CNA4 are the same as each other, trenches TRC1 and TRC2 of the first corner area CNA1 will be representatively described below with reference to FIG. 7.

As illustrated in FIG. 7, a first trench TRC1 and a second trench TRC2 may be disposed in the first corner area CNA1. However, the number of trenches is not limited thereto, and may be variously modified.

The first trench TRC1 and the second trench TRC2 may prevent the cover layer CVL from overflowing to the outside when the cover layer CVL is formed.

In a plan view, in the first corner area CNA1, the first trench TRC1 may be disposed between the first cover corner CC1 and the first main corner MC1. The first trench TRC1 may include a first sub-trench STRC1, a second sub-trench STRC2, and a third sub-trench STRC3 connected to each other. The first sub-trench STRC1, the second sub-trench STRC2, and the third sub-trench STRC3 may be formed integrally with each other.

In a plan view, the first sub-trench STRC1 may have a curved shape. The first sub-trench STRC1 may extend along the first cover corner CC1. For example, the first sub-trench STRC1 may extend along the first cover corner CC1 from the fifth cover side CS5 toward the sixth cover side CS6. An extension direction of the first sub-trench STRC1 may be parallel to an extension direction of the first cover corner CC1.

In a plan view, the second sub-trench STRC2 may have a straight shape. The second sub-trench STRC2 may be connected to one side of the first sub-trench STRC1 and one side of the first main corner MC1. The second sub-trench STRC2 may extend from one side of the first sub-trench STRC1 toward one side of the first main corner MC1. The second sub-trench STRC2 may extend along the first direction DR1. For example, the second sub-trench STRC2 may extend in parallel with the fifth cover side CS5. The second sub-trench STRC2 may be adjacent to the fifth cover side CS5.

In a plan view, the third sub-trench STRC3 may have a straight shape. The third sub-trench STRC3 may be connected to the other side of the first sub-trench STRC1 and the other side of the first main corner MC1. The third sub-trench STRC3 may extend from the other side of the first sub-trench STRC1 toward the other side of the first main corner MC1. The third sub-trench STRC3 may extend along the second direction DR2. For example, the third sub-trench STRC3 may extend in parallel with the sixth cover side CS6. The third sub-trench STRC3 may be adjacent to the sixth cover side CS6.

In a plan view, the second trench TRC2 may be disposed between the first trench TRC1 and the first main corner MC1. The second trench TRC2 may include a first sub-trench STRC11, a second sub-trench STRC22, and a third sub-trench STRC33 connected to each other. The first sub-trench STRC11, the second sub-trench STRC22, and the third sub-trench STRC33 may be formed integrally with each other.

In a plan view, the first sub-trench STRC11 may have a curved shape. The first sub-trench STRC11 may extend along the first cover corner CC1. For example, the first sub-trench STRC11 may extend along the first cover corner CC1 from the fifth cover side CS5 toward the sixth cover side CS6. An extension direction of the first sub-trench STRC11 may be parallel to the extension direction of the first cover corner CC1. A curvature of the first sub-trench STRC11 included in the second trench TRC2 may be smaller than a curvature of the first sub-trench STRC1 included in the first trench TRC1.

In a plan view, the second sub-trench STRC22 may have a straight shape. The second sub-trench STRC22 may be connected to one side of the first sub-trench STRC11 and one side of the first main corner MC1. The second sub-trench STRC22 may extend from one side of the first sub-trench STRC11 toward one side of the first main corner MC1. The second sub-trench STRC22 may extend along the first direction DR1. For example, the second sub-trench STRC22 may extend in parallel with the fifth cover side CS5. The second sub-trench STRC22 may be adjacent to the fifth cover side CS5. A length of the second sub-trench STRC22 included in the second trench TRC2 may be smaller than a length of the second sub-trench STRC2 included in the first trench TRC1.

In a plan view, the third sub-trench STRC33 may have a straight shape. The third sub-trench STRC33 may be connected to the other side of the first sub-trench STRC11 and the other side of the first main corner MC1. The third sub-trench STRC33 may extend from the other side of the first sub-trench STRC11 toward the other side of the first main corner MC1. The third sub-trench STRC33 may extend along the second direction DR2. For example, the third sub-trench STRC33 may extend in parallel with the sixth cover side CS6. The third sub-trench STRC33 may be adjacent to the sixth cover side CS6. A length of the third sub-trench STRC33 included in the second trench TRC2 may be smaller than a length of the third sub-trench STRC3 included in the first trench TRC1.

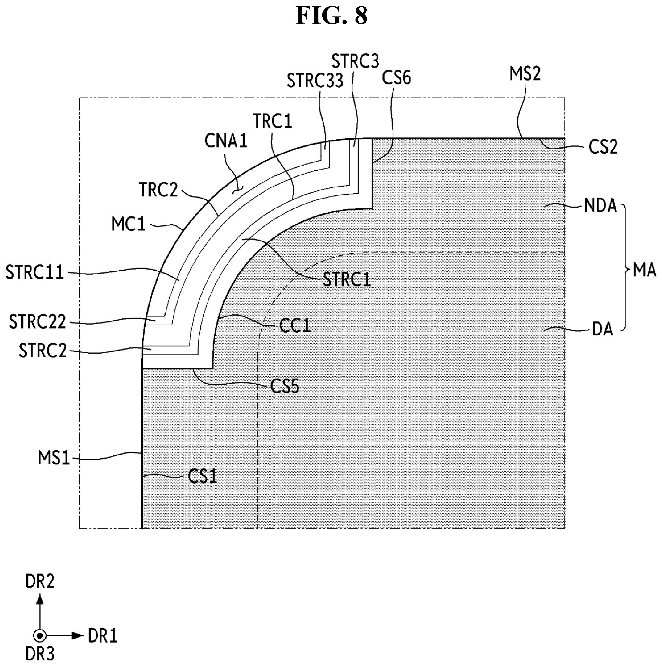

FIG. 8 is an enlarged view of the area A of the display panel 100 of FIG. 6 according to one or more embodiments.

The display panel 100 illustrated in FIG. 8 is different from the display panel 100 described above with reference to FIG. 7 in a size of a corner area, and such a difference will be mainly described below.

A first corner area CNA1 illustrated in FIG. 8 may have a smaller size than the first corner area CNA1 illustrated in FIG. 7.

In this case, a second corner area CNA2 (e.g., as illustrated in FIG. 6) may have a smaller size than the second corner area CNA2 of the embodiment illustrated in FIG. 7, a third corner area CNA3 (e.g., as illustrated in FIG. 6) may have a smaller size than the third corner area CNA3 of the embodiment illustrated in FIG. 7, and a fourth corner area CNA4 (e.g., as illustrated in FIG. 6) may have a smaller size than the fourth corner area CNA4 of the embodiment illustrated in FIG. 7.

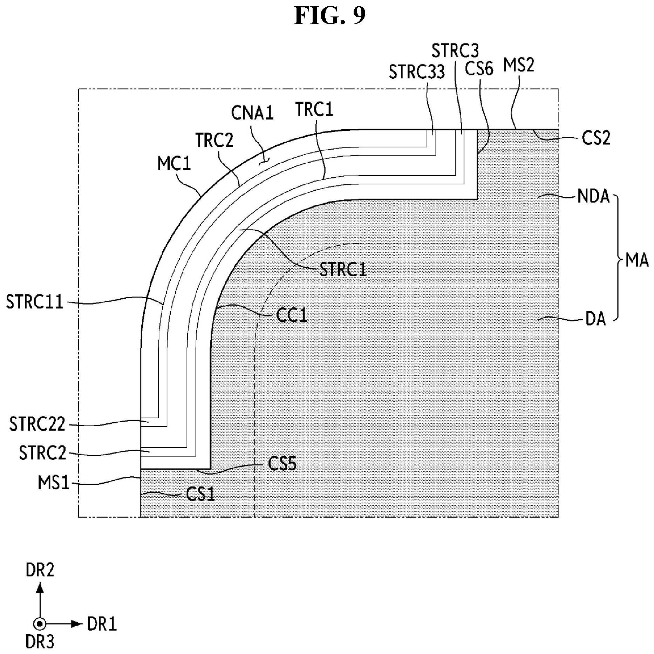

FIG. 9 is an enlarged view of the area A of the display panel 100 of FIG. 6 according to one or more embodiments.

The display panel 100 illustrated in FIG. 9 is different from the display panel 100 described above with reference to FIG. 7 in a size of a corner area, and such a difference will be mainly described below.

A first corner area CNA1 illustrated in FIG. 9 may have a greater size than the first corner area CNA1 illustrated in FIG. 7.

In this case, a second corner area CNA2 (e.g., as illustrated in FIG. 6) may have a greater size than the second corner area CNA2 of the embodiment illustrated in FIG. 7, a third corner area CNA3 (e.g., as illustrated in FIG. 6) may have a greater size than the third corner area CNA3 of the embodiment illustrated in FIG. 7, and a fourth corner area CNA4 (e.g., as illustrated in FIG. 6) may have a greater size than the fourth corner area CNA4 of the embodiment illustrated in FIG. 7.

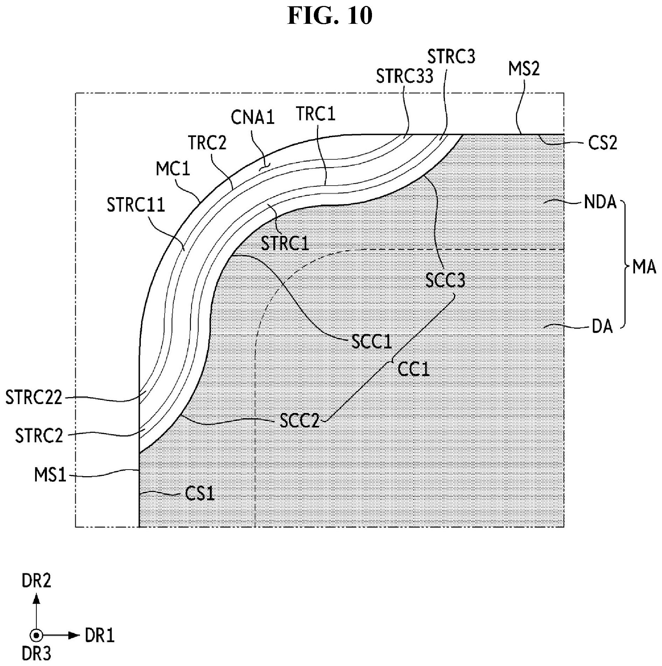

FIG. 10 is an enlarged view of the area A of the display panel 100 of FIG. 6 according to one or more embodiments.

The display panel 100 illustrated in FIG. 10 is different from the display panel 100 described above with reference to FIG. 7 in a shape of a first cover corner CC1 and shapes of trenches TRC1 and TRC2, and such a difference will be mainly described below.

As illustrated in FIG. 10, the first cover corner CC1 may have a curved shape. In this case, the first cover corner CC1 may include a plurality of sub-cover corners SCC1, SCC2, and SCC3 that protrude convexly toward different directions. For example, the first cover corner CC1 may include a first sub-cover corner SCC1, a second sub-cover corner SCC2, and a third sub-cover corner SCC3 that protrude convexly toward different directions.

The first sub-cover corner SCC1 may have a curved shape in which it protrudes convexly toward the first main corner MC1.

The second sub-cover corner SCC2 may extend from one end of the first sub-cover corner SCC1 and may be connected to one side of the first main corner MC1. The second sub-cover corner SCC2 may have a curved shape in which it protrudes in a direction opposite to a protrusion direction of the first sub-cover corner SCC1. For example, the second sub-cover corner SCC2 may have a curved shape in which it protrudes toward the display area DA.

The third sub-cover corner SCC3 may extend from the other end of the first sub-cover corner SCC1 and may be connected to the other side of the first main corner MC1. The third sub-cover corner SCC3 may have a curved shape in which it protrudes in the direction opposite to the protrusion direction of the first sub-cover corner SCC1. For example, the third sub-cover corner SCC3 may have a curved shape in which it protrudes toward the display area DA.

As illustrated in FIG. 10, the first trench TRC1 may have a curved shape. In this case, the first trench TRC1 may include a plurality of sub-trench STRC1, STRC2, and STRC3 that protrude convexly toward different directions. For example, the first trench TRC1 may include a first sub-trench STRC1, a second sub-trench STRC2, and a third sub-trench STRC3 that protrude convexly toward different directions.

The first sub-trench STRC1 may have a curved shape in which it protrudes convexly toward the first main corner MC1.

The second sub-trench STRC2 may extend from one end of the first sub-trench STRC1 and may be connected to one side of the first main corner MC1. The second sub-trench STRC2 may have a curved shape in which it protrudes in a direction opposite to a protrusion direction of the first sub-trench STRC1. For example, the second sub-trench STRC2 may have a curved shape in which it protrudes toward the display area DA.

The third sub-trench STRC3 may extend from the other end of the first sub-trench STRC1 and may be connected to the other side of the first main corner MC1. The third sub-trench STRC3 may have a curved shape in which it protrudes in a direction opposite to the protrusion direction of the first sub-trench STRC1. For example, the third sub-trench STRC3 may have a curved shape in which it protrudes toward the display area DA.

The second trench TRC2 may be disposed between the first trench TRC1 and the first main corner MC1. The second trench TRC2 may have a curved shape. In this case, the second trench TRC2 may include a plurality of sub-trenches STRC11, STRC22, and STRC33 that protrude convexly toward different directions. For example, the second trench TRC2 may include a first sub-trench STRC11, a second sub-trench STRC22, and a third sub-trench STRC33 that protrude convexly toward different directions. The first sub-trench STRC11, the second sub-trench STRC22, and the third sub-trench STRC33 of the second trench TRC2 may have the same shapes as the first sub-trench STRC1, the second sub-trench STRC2, and the third sub-trench STRC3 of the first trench TRC1 described above, respectively.

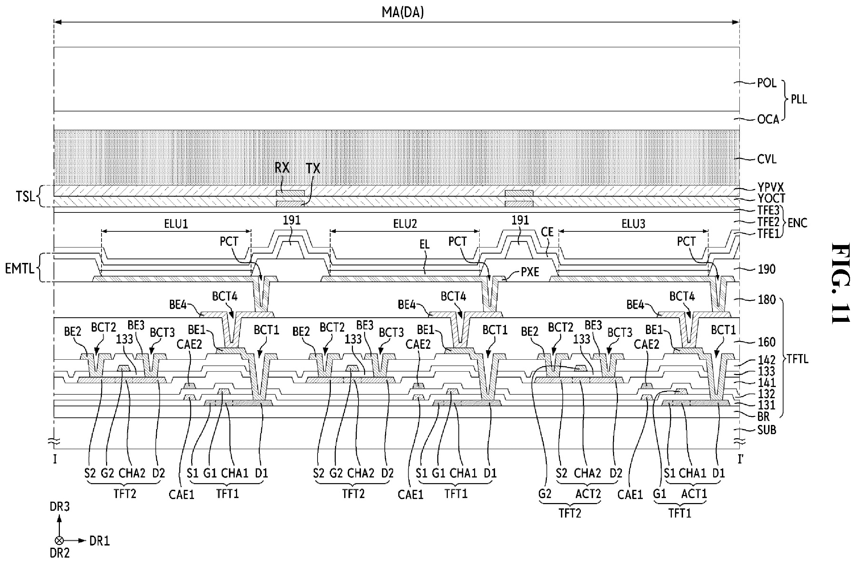

FIG. 11 is a cross-sectional view of the display device 10 taken along the line I-I' of FIG. 7, according to one or more embodiments.

Referring to FIG. 11, a substrate SUB may be made of an insulating material such as glass or a polymer resin (e.g., polyimide).

A barrier film BR may be disposed on the substrate SUB. The barrier film BR is a film for protecting thin film transistors TFT1 and TFT2 and a light emitting layer EL from moisture permeating through the substrate SUB vulnerable to moisture permeation. The barrier film BR may include a plurality of inorganic films that are alternately stacked.

A first thin film transistor TFT1 may be disposed on the barrier film BR. The first thin film transistor TFT1 may be one of the fifth transistor T5 or the sixth transistor T6 illustrated in FIG. 5. The first thin film transistor TFT1 may include a first active layer ACT1 and a first gate electrode G1.

The first active layer ACT1 of the first thin film transistor TFT1 may be disposed on the barrier film BR. The first active layer ACT1 of the first thin film transistor TFT1 may include polycrystalline silicon, single crystal silicon, low-temperature polycrystalline silicon, and/or amorphous silicon.

The first active layer ACT1 may include a first channel region CHA1, a first source region S1, and a first drain region D1. The first channel region CHA1 may be a region overlapping the first gate electrode G1 in the third direction DR3, which is a thickness direction of the substrate SUB. The third direction DR3 may be defined as the thickness direction of the substrate SUB or a thickness direction of the display panel 100. The first source region S1 may be disposed on one side of the first channel region CHA1, and the first drain region D1 may be disposed on the other side of the first channel region CHA1. The first source region S1 and the first drain region D1 may be regions that do not overlap the first gate electrode G1 in the third direction DR3. The first source region S1 and the first drain region D1 may be regions having conductivity by doping a semiconductor material with ions.

A first gate insulating film 131 may be disposed on the first channel region CHA1, the first source region S1, and the first drain region D1 of the first thin film transistor TFT1 and on the barrier film BR.

A first gate metal layer may be disposed on the first gate insulating film 131. The first gate metal layer may include the first gate electrode G1 of the first thin film transistor TFT1 and a first capacitor electrode CAE1. The first gate electrode G1 may overlap the first active layer ACT1 in the third direction DR3.

A second gate insulating film 132 may be disposed on the first gate electrode G1 of the first thin film transistor TFT1, the first capacitor electrode CAE1, and on the first gate insulating film 131.

A second gate metal layer may be disposed on the second gate insulating film 132. The second gate metal layer may include a second capacitor electrode CAE2. The second capacitor electrode CAE2 may overlap the first capacitor electrode CAE1 in the third direction DR3. Because the second gate insulating film 132 has a selected dielectric constant, the capacitor Cst (see FIG. 5) may be formed by the first capacitor electrode CAE1, the second capacitor electrode CAE2, and the second gate insulating film 132 disposed between the first capacitor electrode CAE1 and the second capacitor electrode CAE2.

A first interlayer insulating film 141 may be disposed on the second capacitor electrode CAE2 and on the second gate insulating film 132.

A second thin film transistor TFT2 may be disposed on the first interlayer insulating film 141. The second thin film transistor TFT2 may be one of the second transistor T2 or the third transistor T3 illustrated in FIG. 5. The second thin film transistor TFT2 may include a second active layer ACT2 and a second gate electrode G2.

The second active layer ACT2 of the second thin film transistor TFT2 may be disposed on the first interlayer insulating film 141. The second active layer ACT2 may include an oxide semiconductor. For example, the second active layer ACT2 may include IGZO (indium (In), gallium (Ga), zinc (Zn), and oxygen (O)), IGZTO (indium (In), gallium (Ga), zinc (Zn), tin (Sn), and oxygen (O)), or IGTO (indium (In), gallium (Ga), tin (Sn) and oxygen (O)).

The second active layer ACT2 may include a second channel region CHA2, a second source region S2, and a second drain region D2. The second channel region CHA2 may be a region overlapping the second gate electrode G2 in the third direction DR3. The second source region S2 may be disposed on one side of the second channel region CHA2, and the second drain region D2 may be disposed on the other side of the second channel region CHA2. The second source region S2 and the second drain region D2 may be regions that do not overlap the second gate electrode G2 in the third direction DR3. The second source region S2 and the second drain region D2 may be regions having conductivity by doping an oxide semiconductor with ions.

A third gate insulating film 133 may be disposed on the second active layer ACT2 of the second thin film transistor TFT2 and on the first interlayer insulating film 141.

A third gate metal layer may be disposed on the third gate insulating film 133. The third gate metal layer may include the second gate electrode G2 of the second thin film transistor TFT2. The second gate electrode G2 may overlap the second active layer ACT2 in the third direction DR3.

A second interlayer insulating film 142 may be disposed on the second gate electrode G2 of the second thin film transistor TFT2 and on the third gate insulating film 133.

A first data metal layer may be disposed on the second interlayer insulating film 142. The first data metal layer may include a first connection electrode BE1, a second connection electrode BE2, and a third connection electrode BE3. The first connection electrode BE1 may be connected to the first drain region D1 of the first active layer ACT1 through a first connection hole BCT1 penetrating through the first gate insulating film 131, the second gate insulating film 132, the first interlayer insulating film 141, the third gate insulating film 133, and the second interlayer insulating film 142. The second connection electrode BE2 may be connected to the second source region S2 of the second active layer ACT2 through a second connection hole BCT2 penetrating through the second interlayer insulating film 142 and the third gate insulating film 133. The third connection electrode BE3 may be connected to the second drain region D2 of the second active layer ACT2 through a third connection hole BCT3 penetrating through the second interlayer insulating film 142 and the third gate insulating film 133.

A first organic film 160 for planarizing a step due to the first thin film transistor TFT1 and the second thin film transistor TFT2 may be disposed on the first connection electrode BE1, the second connection electrode BE2, and the third connection electrode BE3 and on the second interlayer insulating film 142.

A second data metal layer may be disposed on the first organic film 160. The second data metal layer may include a fourth connection electrode BE4. The fourth connection electrode BE4 may be connected to the first connection electrode BE1 through a fourth connection hole BCT4 penetrating through the first organic film 160.

A second organic film 180 may be disposed on the fourth connection electrode BE4 and on the first organic film 160.

Each of the barrier film BR, the first gate insulating film 131, the second gate insulating film 132, the third gate insulating film 133, the first interlayer insulating film 141, and the second interlayer insulating film 142 may be formed as an inorganic film made of silicon nitride (SiNₓ), silicon oxynitride (SiON), silicon oxide (SiOₓ), titanium oxide (TiOₓ), and/or aluminium oxide (AlOₓ).

Each of the first gate metal layer, the second gate metal layer, the third gate metal layer, the first data metal layer, and the second data metal layer may be formed as a single layer or multiple layers made of molybdenum (Mo), aluminium (Al), chromium (Cr), gold (Au), titanium (Ti), nickel (Ni), neodymium (Nd), and/or copper (Cu), and/or alloys thereof.

Each of the first organic film 160 and the second organic film 180 may be formed as an organic film made of an acrylic resin, an epoxy resin, a phenolic resin, a polyamide resin, a polyimide resin, and/or the like.

The light emitting element layer EMTL may be disposed on the second organic film 180. For example, a plurality of light emitting elements ED and a bank 190 may be disposed on the second organic film 180. Each of the plurality of light emitting elements ED may include a pixel electrode PXE, a light emitting layer EL, and a common electrode CE. Each of the plurality of light emitting elements ED refers to an element in which holes from the pixel electrode PXE and electrons from the common electrode CE are recombined with each other in the light emitting layer EL to emit light. Each of the plurality of light emitting elements ED may be an organic light emitting diode (OLED) in which the light emitting layer EL is an organic light emitting layer, but the present disclosure is not limited thereto.

A pixel electrode layer may be disposed on the second organic film 180. The pixel electrode layer may include the pixel electrodes PXE. Each of the pixel electrodes PXE may be connected to the fourth connection electrode BE4 through a pixel connection hole PCT penetrating through the second organic film 180. Each of the pixel electrodes PXE may be connected to the first source region S1 or the first drain region D1 of the first thin film transistor TFT1 through the first connection electrode BE1 and the fourth connection electrode BE4. Therefore, a voltage controlled by the first thin film transistor TFT1 may be applied to each of the pixel electrodes PXE. The pixel electrode layer may be formed as a single layer or multiple layers made of molybdenum (Mo), aluminium (Al), chromium (Cr), gold (Au), titanium (Ti), nickel (Ni), neodymium (Nd), and/or copper (Cu), and/or alloys thereof.

The bank 190 serves to define first to third light emitting units ELU1, ELU2, and ELU3 of display pixels. To this end, the bank 190 may be formed on the second organic film 180 so as to expose a partial area of the pixel electrode PXE. The bank 190 may cover an edge of the pixel electrode PXE.

A spacer 191 for stably supporting a mask in a process of depositing the light emitting layer EL may be disposed on the bank 190.

Each of the bank 190 and the spacer 191 may be formed as an organic film made of an acrylic resin, an epoxy resin, a phenolic resin, a polyamide resin, a polyimide resin, and/or the like.

Each of the light emitting layers EL may be exposed without being covered by the bank 190, and may be disposed on the pixel electrode PXE corresponding thereto. Each of the light emitting layers EL may include an organic material and emit selected light. For example, the light emitting layer EL of the first light emitting unit ELU1 may emit first light, the light emitting layer EL of the second light emitting unit ELU2 may emit second light, and the light emitting layer EL of the third light emitting unit ELU3 may emit third light. Each of the light emitting layers EL may include a hole transporting layer, an organic material layer, and an electron transporting layer.

The common electrode CE may be disposed on the light emitting layers EL and the bank 190. The common electrode CE may cover an upper surface of each of the light emitting layers EL and an upper surface of the bank 190 and the spacer 191. The common electrode CE may be disposed in common over the entire display area DA. The common electrode CE may also be disposed in a portion of the non-display area NDA.

The common electrode CE may be made of a transparent conductive material (TCO) such as indium tin oxide (ITO) and/or indium zinc oxide (IZO) capable of transmitting light in a top emission structure or a semi-transmissive conductive material such as magnesium (Mg), silver (Ag), and/or an alloy of magnesium (Mg) and silver (Ag). When the common electrode CE is made of the semi-transmissive conductive material, light emission efficiency of each of the light emitting elements ED may be increased by a micro cavity.

The encapsulation layer ENC may be disposed on the common electrode CE. The encapsulation layer ENC may include at least one inorganic film in order to prevent oxygen or moisture from permeating into the light emitting layer EL. In addition, the encapsulation layer ENC may include at least one organic film in order to prevent an air gap from occurring in at least one inorganic film due to foreign substances such as dust.

The encapsulation layer ENC may include a first encapsulation inorganic film TFE1, an encapsulation organic film TFE2, and a second encapsulation inorganic film TFE3 that are sequentially stacked. The first encapsulation inorganic film TFE1 may be disposed on the common electrode CE, the encapsulation organic film TFE2 may be disposed on the first encapsulation inorganic film TFE1, and the second encapsulation inorganic film TFE3 may be disposed on the encapsulation organic film TFE2.

The first encapsulation inorganic film TFE1 and the second encapsulation inorganic film TFE3 may be formed as multiple films in which one or more inorganic films of a silicon nitride (SiNₓ) film, a silicon oxynitride (SiON) film, a silicon oxide (SiOₓ) film, a titanium oxide (TiOₓ) film, and an aluminium oxide (AlOₓ) film are alternately stacked. The encapsulation organic film TFE2 may be formed as an organic film made of an acryl resin, an epoxy resin, a phenolic resin, a polyamide resin, and/or a polyimide resin.

A touch sensor layer TSL may be disposed on the encapsulation layer ENC. The touch sensor layer TSL may include the touch sensor unit TSU described above.

The touch sensor layer TSL may include a touch inorganic film YOCT, a first touch electrode TX, a touch organic film YPVX, and a second touch electrode RX. The first touch electrode TX may be disposed on the second encapsulation inorganic film TFE3, the touch inorganic film YOCT may be disposed on the first touch electrode TX, the second touch electrode RX may be disposed on the touch inorganic film YOCT, and the touch organic film YPVX may be disposed on the second touch electrode RX.

The cover layer CVL may be disposed on the touch sensor layer TSL. For example, the cover layer CVL may be disposed on the touch organic film YPVX of the touch sensor layer TSL.

A polarizing layer PLL for preventing deterioration of visibility due to external light may be disposed on the cover layer CVL. The polarizing layer PLL may include an adhesive layer OCA disposed on the cover layer CVL and a polarizing film POL disposed on the adhesive layer OCA. The polarizing film POL may include a linear polarizing plate and a phase retardation film such as a λ/4 plate (quarter-wave plate). The polarizing layer may be replaced with another anti-reflection layer such as a color filter layer including a plurality of color filters. The adhesive layer may include an optical adhesive film.

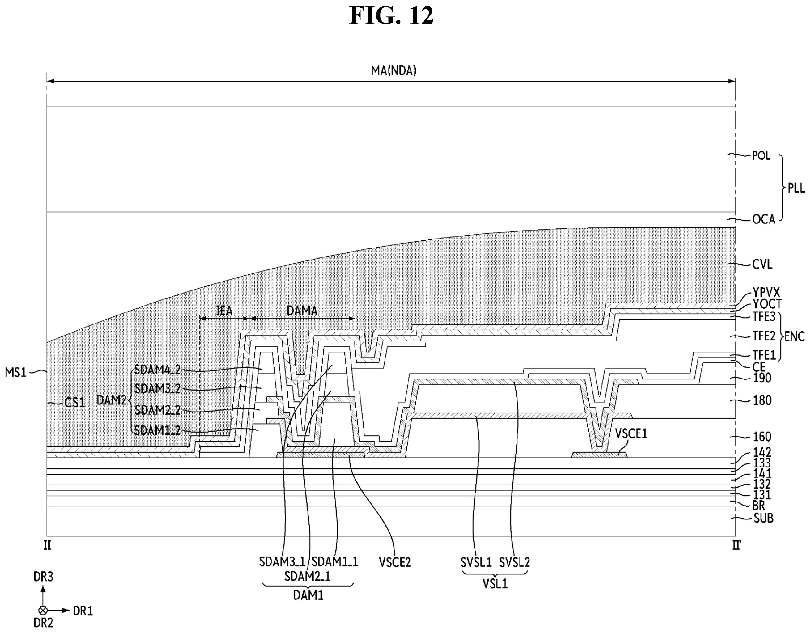

FIG. 12 is a cross-sectional view of the display device 10 taken along the line II-II' of FIG. 7 according to one or more embodiments. For example, FIG. 12 may be a cross-sectional view taken along the first main side MS1 and the periphery of the first main side MS1 in the non-display area NDA of the display device 10.

Referring to FIG. 12, the first data metal layer may include a first power connection electrode VSCE1 and a second power connection electrode VSCE2. The first power connection electrode VSCE1 and the second power connection electrode VSCE2 may be disposed on the second interlayer insulating film 142 in a dam area DAMA.

A first power line VSL1 includes a first sub-power line SVSL1 and a second sub-power line SVSL2.

The first sub-power line SVSL1 may be disposed on the first organic film 160. The first sub-power line SVSL1 may be connected to the first power connection electrode VSCE1. For example, as shown in FIG. 12, the first sub-power line SVSL1 may be connected to the first power connection electrode VSCE1 through a connection hole penetrating through the first organic film 160. The first sub-power line SVSL1 may be disposed on the second power connection electrode VSCE2.

The second sub-power line SVSL2 may be disposed on the second organic film 180 and the first sub-power line SVSL1. For example, as shown in FIG. 12, the second sub-power line SVSL2 may be connected to the first sub-power line SVSL1 through a connection hole penetrating through the second organic film 180.

The common electrode CE may be disposed on the second organic film 180 exposed without covered by the bank 190 and the bank 190. The common electrode CE may be connected to the second sub-power line SVSL2.

A first dam DAM1 and a second dam DAM2 of the dam area DAMA may be disposed on the first power line VSL1.

The first dam DAM1 and the second dam DAM2 may be structures for preventing the encapsulation organic film TFE2 from overflowing into an edge of the display panel 100. The first dam DAM1 and the second dam DAM2 may be structures for confining the encapsulation organic film TFE2.

The first dam DAM1 may include a first sub-dam SDAM1_1, a second sub-dam SDAM2_1, and a third sub-dam SDAM3_1 that are sequentially stacked on the first power line VSL1. The first sub-dam SDAM1_1 may be made of the same material as the second organic film 180, the second sub-dam SDAM2_1 may be made of the same material as the bank 190, and the third sub-dam SDAM3_1 may be made of the same material as the spacer 191.

The second sub-power line SVSL2 may be disposed on the first sub-dam SDAM1_1 of the first dam DAM1. The second sub-dam SDAM2_1 of the first dam DAM1 may be disposed on the second sub-power line SVSL2.

The second dam DAM2 may include a first sub-dam SDAM1_2, a second sub-dam SDAM2_2, a third sub-dam SDAM3_2, and a fourth sub-dam SDAM4_2 that are sequentially stacked on the second interlayer insulating film 142. The first sub-dam SDAM1_2 may be made of the same material as the first organic film 160, and the second sub-dam SDAM2_2 may be made of the same material as the second organic film 180. The third sub-dam SDAM3_2 may be made of the same material as the bank 190, and the fourth sub-dam SDAM4_2 may be made of the same material as the spacer 191.

The first sub-dam SDAM1_2 of the second dam DAM2 may be disposed on the second power connection electrode VSCE2. In addition, the first sub-power line SVSL1 may be disposed on the first sub-dam SDAM1_2 of the second dam DAM2, and the second sub-dam SDAM2_2 of the second dam DAM2 may be disposed on the first sub-power line SVSL1. In addition, the second sub-power line SVSL2 may be disposed on the second sub-dam SDAM2_2 of the second dam DAM2, and the third sub-dam SDAM3_2 of the second dam DAM2 may be disposed on the second sub-power line SVSL2.

Outside the second dam DAM2, an inorganic encapsulation area IEA including only inorganic films due to contact between the first encapsulation inorganic film TFE1 and the second encapsulation inorganic film TFE3 may be disposed. The encapsulation organic film TFE2 is not disposed in the inorganic encapsulation area IEA. The display area DA is surrounded by the inorganic encapsulation area IEA, and it is thus possible to prevent external oxygen and/or moisture from permeating into the light emitting layer EL of the display area DA.

The touch inorganic film YOCT may be disposed on the second encapsulation inorganic film TFE3, and the touch organic film YPVX may be disposed on the touch inorganic film YOCT.

The cover layer CVL may be disposed on the touch organic film YPVX. In this case, the first cover side CS1 of the cover layer CVL may overlap the first main side MS1 of the main area MA included in the display panel 100. For example, the first cover side CS1 of the cover layer CVL may overlap the first main side MS1 of the substrate SUB included in the display panel 100. In other words, the first cover side CS1 of the cover layer CVL and the first main side MS1 of the substrate SUB included in the display panel 100 may be aligned with each other in the third direction DR3.

The polarizing layer PLL may be disposed on the cover layer CVL. For example, the adhesive layer OCA of the polarizing layer may be disposed on the cover layer CVL, and the polarizing film POL of the polarizing layer PLL may be disposed on the adhesive layer OCA.

FIG. 13 is a cross-sectional view of the display device 10 taken along the line III-III' of FIG. 7 according to one or more embodiments. For example, FIG. 13 may be a cross-sectional view taken along the first main corner MC1 and the periphery of the first main corner MC1 in the non-display area NDA of the display device 10.

The display device 10 of FIG. 13 is different from the display device 10 described above with reference to FIG. 12 in that it further includes trenches TRC1 and TRC2 and in a shape of the cover layer CVL, and such differences will be mainly described below.

As illustrated in FIG. 13, the first trench TRC1 and the second trench TRC2 may be disposed between the first cover corner CC1 of the cover layer CVL and the first main corner MC1 of the main area MA included in the display panel 100.

The first trench TRC1 may be disposed between the first cover corner CC1 and the second trench TRC2. The first trench TRC1 may penetrate through the touch inorganic film YOCT and the touch organic film YPVX in the third direction DR3. An inner portion of the first trench TRC1 may be filled with the adhesive layer OCA of the polarizing layer PLL.

The second trench TRC2 may be disposed between the first trench TRC1 and the first main corner MC1. The second trench TRC2 may penetrate through the touch inorganic film YOCT and the touch organic film YPVX in the third direction DR3. An inner portion of the second trench TRC2 may be filled with the adhesive layer OCA of the polarizing layer PLL.

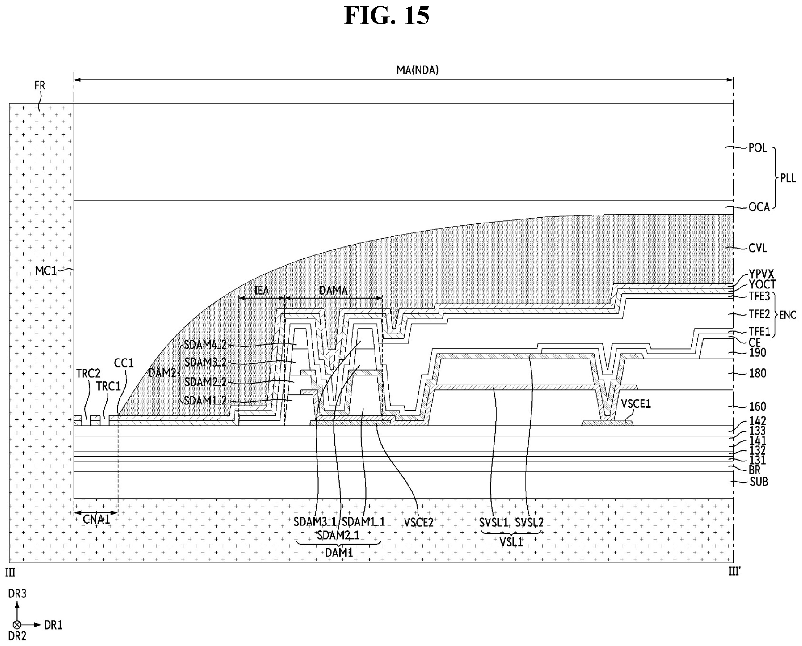

FIGS. 14 and 15 are views for describing an effect of the display device 10 according to one or more embodiments.

As illustrated in FIGS. 14 and 15, a frame FR may be disposed along a side edge of the display panel 100 including an edge of the main area MA, a lower surface of the display panel 100 (e.g., a lower surface of the substrate SUB), and an edge of the polarizing layer PLL. For example, an electronic device including the display device 10 according to one or more embodiments may include a frame FR. The frame FR may protect the display device 10.

The frame FR may be closely adhered to the display device 10 in order to reduce an area of a bezel area of the display device 10, and may be made of a material including resin in order to improve a close adhesion degree between the frame FR and the display device 10.

As illustrated in FIG. 14, the frame FR may be in contact with the main sides MS1, MS2, MS3, and MS4 including the first main side MS1. In this case, because the main sides MS1, MS2, MS3, and MS4 and the cover sides CS1, CS2, CS3, and CS4 overlap each other, the frame FR may be in contact with the cover sides CS1, CS2, CS3, and CS4 including the first cover side CS1 of the cover layer CVL, as illustrated in FIG. 14.

As illustrated in FIG. 15, the frame FR may be in contact with the main corners MC1, MC2, MC3, and MC4 including the first main corner MC1. In this case, because the main corners MC1, MC2, MC3, and MC4 and the cover corners CC1, CC2, CC3, and CC4 are spaced (e.g., spaced apart) from each other, the frame FR may not be in contact with the cover corners CC1, CC2, CC3, and CC4 including the first cover corner CC1.

When stress is applied to the frame FR by external impact, the frame FR may be deformed by the stress. For example, the frame FR made of the resin may be easily deformed by the external impact. The stress applied to the frame FR may propagate to an interface between the cover layer CVL and the touch organic film YPVX having weak adhesive strength. In such a case, a problem in which the cover layer CVL and the touch organic film YPVX may be separated from each other may occur.

As illustrated in FIG. 14, the cover sides CS1, CS2, CS3, and CS4 including the first cover side CS1 of the cover layer CVL extend to the edge of the main area MA so as to overlap the main sides MS1, MS2, MS3, and MS4 including the first main side MS1 of the main area MA, respectively, and thus, the cover layer CVL and the touch organic film YPVX may be in contact with the frame FR. However, the cover layer CVL and the touch organic film YPVX are in contact with each other in a relatively great area around the main sides MS1, MS2, MS3, and MS4 and the cover sides CS1, CS2, CS3, and CS4, such that the cover layer CVL and the touch organic film YPVX at the main sides MS1, MS2, MS3, and MS4 and the cover sides CS1, CS2, CS3, and CS4 may have robust characteristics against external impact. Accordingly, an interface between the cover layer CVL and the touch organic film YPVX at the main sides MS1, MS2, MS3, and MS4 and the cover sides CS1, CS2, CS3, and CS4 may be hardly affected by the stress applied to the frame FR described above.

In addition, as illustrated in FIG. 14, the cover sides CS1, CS2, CS3, and CS4 including the first cover side CS1 of the cover layer CVL extend to the edge of the main area MA so as to overlap the main sides MS1, MS2, MS3, and MS4 including the first main side MS1 of the main area MA, respectively, and thus, the cover layer CVL may have a relatively small step around the main sides MS1, MS2, MS3, and MS4. For example, as illustrated in FIG. 14, an edge of the cover layer CVL including the first cover side CS1 may have a somewhat gentle slope. Accordingly, adhesive strength between the cover layer CVL and the polarizing layer PLL (e.g., the adhesive layer OCA) around the cover sides CS1, CS2, CS3, and CS4 may be improved.

Because the main corners MC1, MC2, MC3, and MC4 of the display panel 100 are areas where the impact described above is easily concentrated, the main corners MC1, MC2, MC3, and MC4 cannot but be vulnerable to the impact. However, as illustrated in FIG. 15, the cover corners CC1, CC2, CC3, and CC4 including the first cover corner CC1 of the cover layer CVL are spaced (e.g., spaced apart) from the frame FR by a selected distance so as not to be in contact with the frame FR, and an interface between the cover layer CVL and the touch organic film YPVX is not in contact with the frame FR due to the trenches TRC1 and TRC2, and thus, the stress applied to the frame FR may not propagate to the interface between the cover layer CVL and the touch organic film YPVX.

Because the cover corners CC1, CC2, CC3, and CC4 including the first cover corner CC1 of the cover layer CVL are spaced (e.g., spaced apart) from the frame FR by a selected distance so as not to be in contact with the frame FR, the cover layer CVL may have a relatively great step around the main corners MC1, MC2, MC3, and MC4. For example, as illustrated in FIG. 15, an edge of the cover layer CVL including the first cover corner CC1 may have a somewhat steep slope. However, because the polarizing layer PLL is attached with stronger pressure to the main corners MC1, MC2, MC3, and MC4 of the display panel 100 than to the main sides MS1, MS2, MS3, and MS4 of the display panel 100 due to characteristics of a process of attaching the polarizing layer PLL to the display panel 100, adhesive strength between the cover layer CVL and the polarizing layer PLL (e.g., the adhesive layer OCA) at the cover corners CC1, CC2, CC3, and CC4 may be maintained strongly.

The display device 10 according to one or more embodiments may be applied to various electronic devices. An electronic device according to one or more embodiments includes the display device 10 described above, and may further include modules or devices having other additional functions in addition to the display device 10.

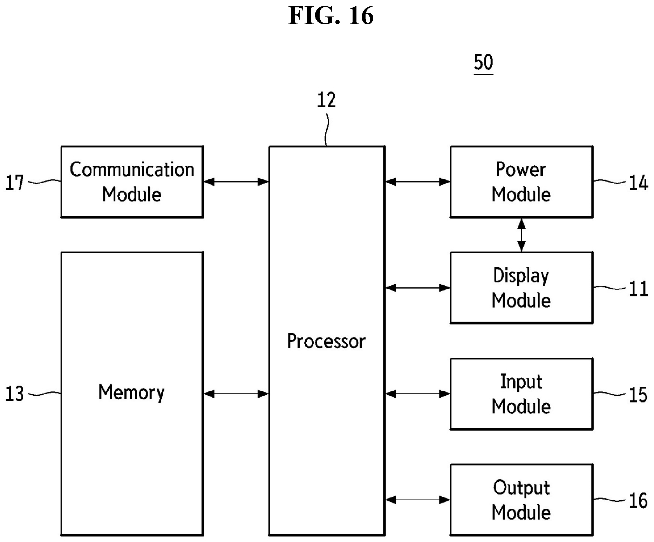

FIG. 16 is a block diagram of an electronic device according to one or more embodiments. Referring to FIG. 16, an electronic device 50 according to one or more embodiments may include a display module 11, a processor 12, a memory 13, and a power module 14. The electronic device 50 may further include an input module 15, an output module 16 (e.g., a non-image output module 16), and/or a communication module 17.

The electronic device 50 may output various information in the form of an image through the display module 11. When the processor 12 executes an application stored in the memory 13, image information provided by the application may be provided to a user through the display module 11. The power module 14 may include a power supply module such as a power adapter or a battery device and a power conversion module converting power supplied by the power supply module to generate power required for an operation of the electronic device 50. The input module 15 may provide input information to the processor 12 and/or the display module 11. The non-image output module 16 may serve to receive information other than an image received from the processor 12, such as sound information, haptic information, and light emitting information, and provide the received information to the user. The communication module 17 is a module in charge of transmitting and receiving information between the electronic device 50 and an external device, and may include a receiving unit and a transmitting unit.

At least one of the respective components of the above-described electronic device 50 may be included in the display device according to the above-described embodiments. In addition, some of individual modules functionally included in one module may be included in the display device, and the others of the individual modules may be provided separately from the display device. For example, the display device may include the display module 11, and the processor 12, the memory 13, and the power module 14 may be provided in the form of other devices within the electronic device 50 rather than the display device.

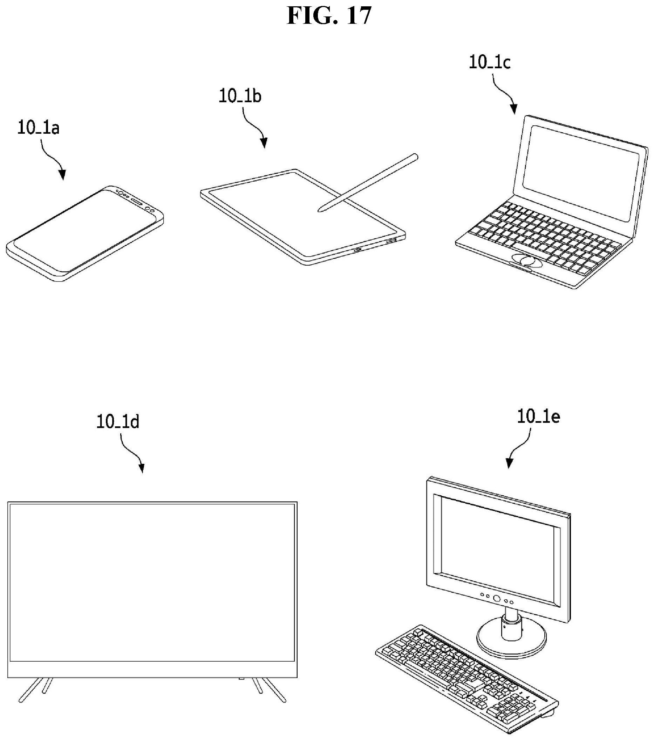

FIGS. 17 - 19 are schematic views of electronic devices according to various embodiments. FIGS. 17 - 19 illustrate examples of various electronic devices to which a display device 10 according to one or more embodiments is applied.

FIG. 17 illustrates a smartphone 10_1a, a tablet PC 10_1b, a laptop computer 10_1c, a television (TV) 10_1d, and a monitor 10_1e for a desktop computer as examples of the electronic devices.

The smartphone 10_1a may include an input module such as a touch sensor and a communication module in addition to the display module 11. The smartphone 10_1a may process information received through the communication module or other input modules and display the processed information through the display module of the display device.

Each of the tablet PC 10_1b, the laptop computer 10_1c, the TV 10_1d, and the monitor 10_1e for a desktop computer may include a display module and an input module, similar to the smartphone 10_1a, and may further include a communication module in some cases.

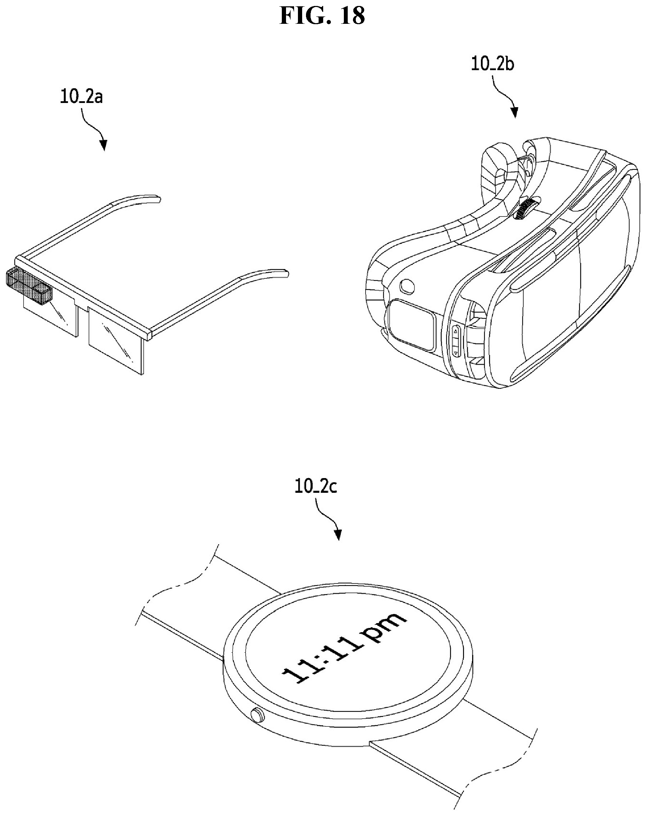

FIG. 18 illustrates a case where an electronic device including a display module is applied to a wearable electronic device. The wearable electronic device may be smart glasses 10_2a, a head mounted display 10_2b, a smart watch 10_2c, and/or the like.

Each of the smart glasses 10_2a and the head mounted display 10_2b may include a display module for displaying a display image and a reflector for reflecting the display image and providing the display image to user's eyes, and accordingly, may provide a virtual reality screen or an augmented reality screen to the user.

The smart watch 10_2c may include a biometric sensor as an input device, and may provide biometric information recognized through the biometric sensor to the user through the display module.

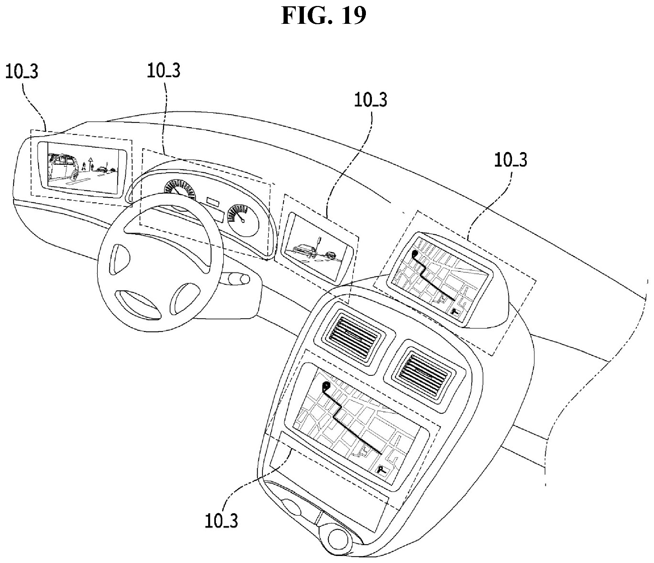

FIG. 19 illustrates a case where an electronic device including a display module is applied to a vehicle. For example, an electronic device 10_3 may be applied to an instrument board, a center fascia, and/or the like, of the vehicle or applied to a center information display (CID) disposed on a dashboard of the vehicle, a room mirror display substituting for a side-view mirror, or the like.

In concluding the detailed description, those skilled in the art will appreciate that many variations and modifications can be made to the embodiments without substantially departing from the principles and scope of the present disclosure. Therefore, the embodiments of the present disclosure are used in a generic and descriptive sense only and not for purposes of limitation.

## Claims

1. A display device (10) comprising:
a substrate (SUB) including a main area (MA);
a light emitting element (ED) on a display area (DA) of the main area (MA); and
a cover layer (CVL) on the display area (DA) and a non-display area (NDA) of the main area (MA) of the substrate (SUB) covering the light emitting element (ED),
wherein an edge of the main area (MA) includes a main side (MS1) and a main corner (MC1), and
wherein an edge of the cover layer (CVL) includes a first cover side (CS1) overlapping the main side (MS1) and a cover corner (CC1) spaced from the main corner (MC1).

2. The display device (10) of claim 1, wherein each of the main corner (MC1) and the cover corner (CC1) has a curved shape.

3. The display device (10) of claim 2, wherein the cover corner (CC1) includes a plurality of sub-cover corners (SCC1, SCC2, SCC3) having curved shapes convex in different directions.

4. The display device (10) of claim 3, wherein the plurality of sub-cover corners (SCC1, SCC2, SCC3) includes:
a first sub-cover corner (SCC1) having a curved shape convex toward the main corner (MS1); and
a second sub-cover corner (SCC2) having a curved shape convex toward the display area (DA) of the main area (MA).

5. The display device (10) of claim 1 or claim 2, further comprising at least one trench (TRC1, TRC2) located between the cover corner (CC1) and the main corner (MC1).

6. The display device (10) of claim 5, wherein the at least one trench (TRC1, TRC2) includes:
a first trench (TRC1) located between the cover corner (CC1) and the main corner (MC1); and
a second trench (TRC2) located between the first trench (TRC1) and the main corner (MC1).

7. The display device (10) of claim 5 or claim 6, wherein the at least one trench (TRC1, TRC2) includes a plurality of sub-trenches (STRC1, STRC2, STRC3, STRC11, STRC22, STRC33) having different shapes.

8. The display device (10) of claim 7, wherein the plurality of sub-trenches (STRC1, STRC2, STRC3, STRC11, STRC22, STRC33) includes:
a first sub-trench (STRC1, STRC11) having a curved shape; and
a second sub-trench (STRC2, STRC22) extending from the first sub-trench (STRC1, STRC11) toward the main corner (MC1) and having a straight shape.

9. The display device (10) of any one of claims 5 to 8, wherein the cover layer (CVL) further includes:
a second cover side (CS2) neighboring to the first cover side (CS1) and connected to the first cover side (CS1) by the cover corner (CC1);
a third cover side (CS5) connecting one side of the cover corner (CC1) and the first cover side (CS1) to each other; and
a fourth cover side (CS6) connecting an other side of the cover corner (CC1) and the second cover side (CS2) to each other, optionally wherein the at least one trench (TRC1, TRC2) is located in a corner area (CNA1) that is surrounded by the cover corner (CC1), the third cover side (CS5), the fourth cover side (CS6), and the main corner (MC1).

10. The display device (10) of claim 1, further comprising:
an encapsulation layer (ENC) on the light emitting element (ED);
a touch inorganic film (YOCT) on the encapsulation layer (ENC); and
a touch organic film (YPVX) on the touch inorganic film (YOCT),
wherein the cover layer (CVL) is on the touch organic film (YPVX).

11. The display device (10) of claim 10, further comprising a trench (TRC1, TRC2) between the cover corner (CC1) and the main corner (MC1) and penetrating through the touch organic film (YPVX) and the touch inorganic film (YOCT), optionally further comprising a polarizing layer (PLL) on the cover layer (CVL),
wherein an adhesive layer (OCA) of the polarizing layer (PLL) is in the trench (TRC1, TRC2).

12. The display device (10) of any one of claims 1 to 11, wherein the cover layer (CVL) has a greater step at the cover corner (CC1) than at the first cover side (CS1).

13. The display device (10) of any one of claims 1 to 12, wherein:
(i) the cover layer (CVL) comprises an organic material; and/or
(ii) the substrate (SUB) further includes a sub-area (SBA) that is adjacent to the main area (MA) and does not overlap the cover layer (CVL), and
wherein the display device (10) further comprises a pad portion (PD) in the sub-area (SBA) and a display driver (200) connected to the pad portion (PD).

14. An electronic device (50) comprising a display device (10) comprising a display screen,
wherein the display device (10) comprises:
a substrate (SUB) including a main area (MA);
a light emitting element (ED) on a display area (DA) of the main area (MA); and
a cover layer (CVL) on the display area (DA) and a non-display area (NDA) of the main area (MA) of the substrate (SUB) covering the light emitting element (ED),
wherein an edge of the main area (MA) includes a main side (MS1) and a main corner (MC1), and
wherein an edge of the cover layer (CVL) includes a cover side (CS1) overlapping the main side (MS1) and a cover corner (CC1) spaced from the main corner (MC1).

15. The electronic device (50) of claim 14, further comprising a frame (FR) located along the main side (MS1) and the main corner (MC1),
wherein the frame (FR) is in contact with the main side (MS1) and the cover side (CS1), optionally wherein:
(i) the frame (FR) and the cover corner (CC1) are not in contact with each other; and/or
(ii) the electronic device (50) comprises a smartphone, a tablet personal computer (PC), a laptop computer, a television (TV), a monitor for a desktop computer, smart glasses, a smart watch, a head mounted display, or a vehicle.
